# EUROPÄISCHE PATENTANMELDUNG

(11) **EP 3 228 727 A2**
(43) Veröffentlichungstag der Anmeldung: **11.10.2017**
(21) Anmeldenummer: 16200227.3
(22) Anmeldetag: 30.03.2016
(51) Int. Cl.: C23C 14/20, B05D 5/06, B05D 7/00, C23C 14/00

(54) **VERFAHREN ZUR HERSTELLUNG BESCHICHTETER SUBSTRATE, BESCHICHTETE SUBSTRATE UND DEREN VERWENDUNG**

(62) Teilanmeldung aus: 16163054.6
(71) Anmelder: HEC High End Coating GmbH, 35108 Allendorf (Eder) (DE)
(72) Erfinder: Koch, Matthias, 59969 Bromskirchen (DE)
(74) Vertreter: Metten, Karl-Heinz

(57) **Zusammenfassung**

Die vorliegende Erfindung betrifft Verfahren zur Herstellung von beschichteten nichtmetallischen Substraten sowie von beschichteten Metallsubstraten. Hierbei zeichnet sich eine Verfahrensvariante dadurch aus, dass unterhalb einer mittels Aufdampf- und/oder Sputter-Technik erhaltenen Metallschicht eine matte oder glänzende Beschichtung vorzuliegen hat, während in einer weiteren Verfahrensvariante die mittels Aufdampf- und/oder SputterTechnik erhaltene Metallschicht derart dünn zu sein hat, dass sie noch stets für das sichtbare Licht transparent oder transluzent ist. Ferner betrifft die Erfindung beschichtete nichtmetallisch Substrate sowie beschichtete Metallsubstrate, die mit den vorangehend genannten Schichten ausgestattet sind. Außerdem betrifft die Erfindung die Verwendung dieser beschichteten nicht-metallischen Substrate sowie dieser beschichteten Metallsubstrate.

## Beschreibung

Die vorliegende Erfindung betrifft Verfahren zur Herstellung beschichteter Substrate, beschichtete Substrate und die Verwendung dieser beschichteten Substrate.

Metallische wie nicht-metallische Bauteile werden häufig zur Erzeugung einer glatten und/oder glänzenden Oberfläche beschichtet. In der Regel handelt es sich hierbei um mehrlagige Beschichtungssysteme. Neben dem Wunsch, eine Oberfläche mit hochwertiger Anmutung zu erhalten, wird mit derartigen Beschichtungssystemen regelmäßig auch ein ausgeprägter Korrosionsschutz angestrebt. Ein dauerhafter Korrosionsschutz wird nicht selten durch mechanische Beschädigung zunichte gemacht. Vielfach setzt bereits bei geringfügigsten mechanischen Beschädigungen beschichteter Oberflächen Korrosion ein. Dies kann neben Verfärbungen auch Unterwanderungsphänomene zur Folge haben. Nicht selten führt dies dann zum Abplatzen von Beschichtungsarealen. Es hat nicht an Versuchen gefehlt, beschichtete glänzende Oberflächen korrosionsbeständig auszustatten. Beispielsweise beschreibt die DE 123 765 A1 ein Verfahren zur Erzeugung einer Korrosionsschutzschicht auf einer metallischen Oberfläche, bei dem ein auf Siliziumverbindungen basierendes Sol, ein Aminoalkyl-funktionallsiertes Alkoxysilan oder ein Umsetzungsprodukt der beiden vorangehend genannten Komponenten zum Einsatz kommt.

Gemäß der DE 38 33 119 C2 erhält man eine sehr gut auf einem Substrat haftende korrosionsgeschützte chromatierte Metalloberfläche dadurch, dass ein Elektrotauchlack direkt auf die Chromatierschicht ohne Zwischentrocknung abgeschieden wird. Korrosionsschutzbeschichtungen für Metallsubstrate zeigen jedoch noch stets erhebliches Verbesserungspotential in Sachen Haftung und Korrosionsschutz, insbesondere bei massengefertigten Produkten, vor allem solchen mit anspruchsvoller Geometrie.

Auch hat es sich als nicht trivial erwiesen, beschichtete metallisch anmutende Substrate mit einem matten oder farbigen Erscheinungsbild kostengünstig und gleichwohl in hoher Qualität, insbesondere massenproduktionsfähig herzustellen.

Der vorliegenden Erfindung lag daher die Aufgabe zu Grunde, beschichtete Substrate zur Verfügung zu stellen, die nicht mehr mit den Nachteilen des Stands der Technik behaftetet sind und die insbesondere auch in der Massenfertigung beschichtete Produkte mit gutem Korrosionsschutz und/oder sehr guten Haftungseigenschaften liefern und die darüber hinaus ein mattes oder farbiges Erscheinungsbild aufweisen. Hierbei werden auch solche beschichteten Produkte angestrebt, die bei mechanischer Oberflächenbeschädigung nicht sogleich Unterwanderungsphänomene zeigen, insbesondere auch nicht verbunden mit dem Abblättern von Schichten.

Demgemäß wurde ein Verfahren zur Herstellung eines beschichteten nicht-metallischen Substrats, insbesondere Kunststoffsubstrats, gefunden, umfassend
a) Zurverfügungstellung eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage,
c) Zurverfügungstellung, mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
d) gegebenenfalls Plasmabehandlung mit dem Plasmagenerator und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer, gegebenenfalls eingefärbten, Grundierungsschicht auf das nicht-metallische Substrat, insbesondere Kunststoffsubstrat, o- der die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
j-k) Aufbringen mindestens einer matten, insbesondere farbigen, Beschichtung, beispielsweise eines Mattlacks, insbesondere mit dem Glanzgrad "mittlerer Glanz" (G2) oder vorzugsweise mit dem Glanzgrad "matt" (G3), jeweils bestimmt gemäß DIN EN ISO 2813:2014 (Ausgabedatum: 2015-02) oder Aufbringen mindestens einer glänzenden, insbesondere farbigen, Beschichtung, beispielsweise eines Glanzlacks, insbesondere mit dem Glanzgrad "glänzend" (G1), bestimmt gemäß DIN EN ISO 2813:2014 (Ausgabedatum: 2015-02), vorzugsweise Aufbringen der matten Beschichtung,
k) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf die Beschichtung gemäß Schritt j-k),
1) gegebenenfalls Plasmabehandlung mit dem Plasmagenerator und/oder Corona-Behandlung der Metallschicht gemäß Schritt k),
m) vorzugsweise Behandeln der nach Schritt k) oder l) erhaltenen Metallschicht mit mindestens einer siliziumorganischen Verbindung, insbesondere mittels Plasmapolymerisation, unter Ausbildung einer Polysiloxanschicht,
n) vorzugsweise Plasmabehandlung mit dem Plasmagenerator und/oder Corona-Behandlung der Polysiloxanschicht gemäß Schritt m) und
o) Auftragen mindestens einer, insbesondere transparenten und/oder eingefärbten, Deckschicht auf die Schicht gemäß Schritt k), l), m) oder n), insbesondere auf die behandelte Polysiloxanschicht gemäß Schritt n).

Bei dem geschilderten Verfahren wird die Metallschicht, insbesondere Aluminiumschicht, in Schritt k) vorzugsweise in einer Dicke aufgetragen, insbesondere aufgedampft oder aufgesputtert, so dass die Metallschicht, insbesondere auch nach Schritt l), m), n) und/oder o), für sichtbares Licht nicht transparent und nicht transluzent ist. Es hat sich überraschend gezeigt, dass, obwohl die Metallschicht in einer Dicke aufgetragen wird, die für das sichtbare Licht nicht transluzent oder sogar nicht transparent ist, das nach diesem Verfahren erhaltene Endprodukt gleichwohl ein mattes Erscheinungsbild liefert. Der matte Charakter wird demgemäß auf die aufgetragene Metallschicht übertragen. Hierdurch kann den nach diesem Verfahren erhaltenen nicht-metallischen Substrat, insbesondere beschichteten Kunststoffprodukten, ein sehr edel anmutendes Erscheinungsbild gegeben werden. Von Vorteil ist hierbei außerdem, dass sich nicht nur durch einen sehr ausgeprägten Korrosionsschutz auszeichnen, sondern, anders als dieses bei Produkten mit matten Oberflächen häufig der Fall ist, mechanische Einwirkungen auf die Oberfläche diese in ihrem Erscheinungsbild nicht beeinträchtigen. Beispielsweise beobachtet man keinen Abrieb bzw. keine Veränderung des matten Erscheinungsbildes an den Stellen, auf die mechanisch eingewirkt wurde. In entsprechender Weise kann durch Verwendung einer glänzenden Beschichtung der Glanz der darüber aufgebrachten Metallschicht nochmals intensiviert werden. Für die Erzeugung einer matten oder glänzenden Beschichtung können beliebige Farben verwendet werden. Wird die Metallschicht deckend aufgebracht, das heißt in einer Weise, dass sie für sichtbares Licht nicht transparent und auch nicht transluzent ist, wird nur der matte bzw. glänzende Charakter der Beschichtung auf die aufgetragene Metallschicht übertragen, nicht jedoch auch die Farbe dieser Beschichtung. Dem Fachmann sind matte und glänzende Beschichtungen bekannt. Matte Beschichtungen können zum Beispiel unter Verwendung einer sogenannten Mattierungspaste erhalten werden.

Im Sinne der vorliegenden Erfindung ist eine solche, insbesondere mittels Aufdampf- oder Sputtertechnik, aufgetragene Metallschicht nicht transparent oder transluzent, die über eine Dicke von mindestens 60, beispielsweise im Bereich von 60 nm bis 120 nm, vorzugsweise im Bereich von 75 nm bis 110 nm verfügt.

Alternativ ist es in einer weiteren, wenngleich nicht bevorzugten Ausführungsform möglich, die Metallschicht, insbesondere Aluminiumschicht, in Schritt k) in einer Dicke aufzutragen, insbesondere aufzudampfen oder aufzusputtern, dass diese für sichtbares Licht transparent oder transluzent ist. Diese transparente oder transluzente Metallschicht weist dabei vorzugsweise eine durchschnittliche, insbesondere absolute, Dicke im Bereich von 1 nm bis 50 nm, vorzugsweise im Bereich von 10 nm bis 40 nm, und besonders bevorzugt im Bereich von 15 nm bis 30 nm, auf.

Die der Erfindung zu Grunde liegende Aufgabe wird des Weiteren durch ein Verfahren zur Herstellung eines beschichteten nicht-metallischen Substrats, insbesondere Kunststoffsubstrats, gelöst, umfassend
a) Zurverfügungstellung eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage,
c) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
d) gegebenenfalls Plasmabehandlung mit dem Plasmagenerators und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer, insbesondere eingefärbten, Grundierungsschicht auf das nicht-metallische Substrat, insbesondere Kunststoffsubstrat, oder die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
jj-kk) vorzugsweise Aufbringen mindestens einer Färbschicht auf das nicht-metallische Substrat oder die beschichtbare Oberfläche des nicht-metallischen Substrats gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j),
k') Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j) oder auf die Farbschicht gemäß Schritt jj-kk), wobei die Metallschicht, insbesondere Aluminiumschicht, in einer Dicke aufgetragen, insbesondere aufgedampft oder aufgesputtert, wird, dass die Metallschicht, insbesondere auch nach Schritt l), m), n) und/oder o), für sichtbares Licht transparent oder transluzent ist,
1) gegebenenfalls Plasmabehandlung mit dem Plasmagenerator und/oder Corona-Behandlung der Metallschicht gemäß Schritt k'),
m) vorzugsweise Behandeln der nach Schritt k') oder l) erhaltenen Metallschicht mit mindestens einer siliziumorganischen Verbindung, insbesondere mittels Plasmapolymerisation, unter Ausbildung einer Polysiloxanschicht,
n) vorzugsweise Plasmabehandlung mit dem Plasmagenerator und/oder Corona-Behandlung der Polysiloxanschicht gemäß Schritt m) und
o) Auftragen mindestens einer, insbesondere transparenten und/oder eingefärbten, Deckschicht auf die Schicht gemäß Schritt k'), l), m) oder n), insbesondere auf die behandelte Polysiloxanschicht gemäß Schritt n).

Die transparente oder transluzente Metallschicht in Schritt k') verfügt vorzugsweise über eine durchschnittliche, insbesondere absolute, Dicke im Bereich von 1 nm bis 50 nm, vorzugsweise im Bereich von 10 nm bis 40 nm, und besonders bevorzugt im Bereich von 15 nm bis 30 nm.

Bei dem vorangehend beschriebenen Verfahren werden in einer bevorzugten Ausführungs- form dem Schritt o) die Schritte m) und n) vorgeschaltet.

Benachbart zur transparenten oder transluzenten Metallschicht (Schicht k'), und zwar jenseits der Deckschicht, liegen vorzugsweise die Farbschicht (Schicht jj-kk)), die farbige bzw. eingefärbte Polysiloxanschicht, die farbige bzw. eingefärbte Grundierungsschicht oder das farbige bzw. eingefärbte nicht-metallische Substrat an. Auf diese Weise können sehr hochwertig anmutende Beschichtungssysteme erhalten werden. Beispielsweise kann durch Verwendung einer schwarzen Farbschicht oder eines schwarz eingefärbten nicht-metallischen Substrats, welche an der transparenten oder transluzenten Metallschicht anliegen, der Eindruck einer Schwarzchromschicht erzeugt werden.

Bei den beiden vorangehend geschilderten Verfahrensvarianten zur Herstellung beschichteter nicht-metallischer Substrate sind u.a. die Schritte d), e) und f) nur optional. Sie können in Einzelfällen zu einer verbesserten Haftung und einem erhöhten Korrosionsschutz beitragen. Das gleiche trifft auf den optionalen Schritt i) zu. Es hat sich für einige Anwendungen gezeigt, dass es von Vorteil ist, wenn beidseitig der Metallschicht eine, insbesondere plasmagenerierte, Polysiloxanschicht vorliegt, die vorzugsweise jeweils einer Plasmabehandlung und/oder einer Corona-Behandlung, insbesondere Plasmabehandlung, unterzogen wurde.

Der optionale Verfahrensschritt der Aufbringung einer Grundierungsschicht bietet sich insbesondere bei nicht-metallischen Substraten, insbesondere Kunststoffsubstraten, mit einer Oberfläche an, die Unebenheiten aufweist bzw. die von minderer Qualität ist.

Bei den beiden vorangehend geschilderten Verfahren zur Beschichtung von nicht-metallischen Substrat, insbesondere Kunststoffsubstraten, haben sich solche Verfahrensvarianten als zweckmäßig erwiesen, bei denen
die Schritte g), h), j-k), k), m), n) und o) oder g), h), k'), m), n) und o) oder g), h), jj-kk), k'), m), n) und o) jeweils, insbesondere unmittelbar, aufeinander folgen, insbesondere unter Auslassung der Schritte d), e) und/oder f) oder unter Einsatz von Schritt d) und unter Auslassung von Schritt e) und f), oder
die Schritte g), h), i), j-k), k), m), n) und o) oder g), h), i), k'), m), n) und o) oder g), h), i), jj-kk), k'), m), n) und o) jeweils, insbesondere unmittelbar, aufeinander folgen, insbesondere unter Auslassung der Schritte d), e) und/oder f) oder unter Einsatz von Schritt d) und unter Auslassung von Schritt e) und f), oder
die Schritte d), e), f), j-k), k), m), n) und o) oder d), e), f), k'), m), n) und o) oder d), e), f), jj-kk), k'), m), n) und o) jeweils, insbesondere unmittelbar, aufeinander folgen oder die Schritte d), e), f), i), j-k), k), m), n) und o) oder d), e), f), i), k'), m), n) und o) oder d), e), f), i), jj-kk), k'), m), n) und o) jeweils, insbesondere unmittelbar, aufeinander folgen oder die Schritte d), e), f), g), j-k), k), m), n) und o) oder d), e), f), g), k'), m), n) und o) oder d), e), f), g), jj-kk), k'), m), n) und o) jeweils, insbesondere unmittelbar, aufeinander folgen oder
die Schritte d), e), f), g), i), j-k), k), m), n) und o) oder d), e), f), g), i), k'), m), n) und o) oder d), e), f), g), i), jj-kk), k'), m), n) und o) jeweils, insbesondere unmittelbar, aufeinander folgen.

In einer bevorzugten Ausführungsform ist vorgesehen, dass jeweils vor dem Schritt der Aufbringung der Metallschicht k) bzw. k') die Aufbringung einer, insbesondere plasmagenerierten, Polysiloxanschicht (Schritt i)) vorgesehen werden kann. Die vorangehend geschilderte Verfahrensvariante kann insbesondere bei einwandfreien nicht-metallischen Substraten, insbesondere Kunststoffsubstraten mit einwandfreier bzw. glatter Oberfläche eingesetzt werden.

In einer besonders zweckmäßigen Ausgestaltung, insbesondere wie vorangehend spezifiziert, wird die Schicht, auf die die Metallschicht gemäß Schritt k) bzw. k') aufgebracht wird, vor dem Schritt k) bzw. k') einer Plasmabehandlung mit dem Plasmagenerator und/oder einer Corona-Behandlung unterzogen (beispielsweise Schritte j), f) oder d)).

Es hat sich als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es regelmäßig nicht erforderlich ist, weitere Verfahrensschritte zwischenzuschalten.

Auch hat es sich in einer bevorzugten Ausführungsform als günstig insbesondere in Bezug auf gute Haftung und Korrosionsschutz erwiesen, wenn das nicht-metallische Substrat, insbesondere das Kunststoffsubstrat, einer Plasmabehandlung und/oder Corona-Behandlung, insbesondere Plasmabehandlung, unterzogen wird (Schritt d)).
Geeignete nicht-metallische Substrate umfassen Glas, Keramik, Verbundfasermaterialien, Carbonmaterialien, Kunststoff, insbesondere ein, vorzugsweise eingefärbtes, Kunststoff-formteil oder eine, vorzugsweise eingefärbte, Kunststoffbeschichtung, oder Holz, insbesondere Holzwerkstoffplatten. Geeignete Holzwerkstoffplatten umfassen z.B. Sperrholz- oder Schichtplatten, Spanwerkstoffplatten, OSB-Platten, MDF-Platten, Faserwerkstoffplatten, Holzwerkstoffplatten aus Vollholz oder mineralisch gebundene Holzwerkstoffplatten. Besonders vorteilhaft haben sich MDF-Platten erwiesen, beispielsweise auch in eingefärbter Form. Dies kann beispielsweise durch Beimengung eingefärbter synthetischer Polymerwerkstoffe vorgenommen werden. Holzsubstrate, beispielsweise Holzwerkstoffplatten wie MDF-Platten können sich auch durch eine Oberflächenstrukturierung auszeichnen, z.B. in Form einer Maserung. Nicht-metallische Substrate im Sinne der Erfindung umfassen demgemäß auch eingefärbte nicht-metallische Substrate.

Besonders gut geeignet ist das hier geschilderte erfindungsgemäße Verfahren für die Beschichtung von Kunststoffsubstraten zwecks Erhalts dauerhaft hochglänzender Produkte. Geeignete Kunststoffsübstrate umfassen oder bestehen z.B. aus PVC, Polyurethanen, Polyacrylaten, Polyestern, z.B. PBT und PET, Polyolefinen, insbesondere Polypropylen, Polycarbonaten, Polyamiden, Polyphenylenethern, Polystyrol, Styrol(co)polymere, wie ABS, SAN, ASA oder MABS, Polyoxyalkylene, z.B. POM, Teflon und Polymerblends, insbesondere ABS/PPE-, ASA/PPE-, SAN/PPE- und/oder ABS/PC-Blends. Kunststoffsubstrate im Sinne der Erfindung umfassen ebenfalls Beschichtungen aus einem Kunststoffmaterial, beispielsweise mit einem Kunststoffmaterial beschichtete MDF-Platten.

Die der Erfindung zu Grunde liegende Aufgabe wird des Weiteren gelöst durch ein Verfahren zur Herstellung eines beschichteten Metallsubstrats, umfassend
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht, insbesondere Vakuumaufdampfanlage,
C) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder der Sputter-Anlage, oder als Bestandteil hiervon,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer, gegebenenfalls eingefärbten, Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerators und/oder Corona-Behandlung der nach Schritt O) erhaltenen behandelten Polysiloxanschicht,
P-Q) Aufbringen mindestens einer matten, insbesondere farbigen, Beschichtung, beispielsweise eines Mattlacks, insbesondere mit dem Glanzgrad "mittlerer Glanz" (G2) oder vorzugsweise mit dem Glanzgrad "matt" (G3), jeweils bestimmt gemäß DIN EN ISO 2813:2014 (Ausgabedatum: 2015-02), oder Aufbringen mindestens einer glänzenden, insbesondere farbigen, Beschichtung, beispielsweise eines Glanzlacks, insbesondere mit dem Glanzgrad "glänzend" (G1), bestimmt gemäß DIN EN ISO 2813:2014 (Ausgabedatum: 2015-02), vorzugsweise Aufbringen der matten Beschichtung,
Q) Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf die Beschichtung gemäß Schritt P-Q)
R) gegebenenfalls Plasmabehandlung mit dem Plasmagenerators und/oder Corona-Behandlung der Metallschicht gemäß Schritt Q),
S) vorzugsweise Behandeln der nach Schritt Q) oder R) erhaltenen Metallschicht mit mindestens einer siliziumorganischen Verbindung, insbesondere mittels Plasmapolymerisation, unter Ausbildung einer Polysiloxanschicht,
T) vorzugsweise Plasmabehandlung mit dem Plasmagenerator und/oder Corona-Behandlung der Polysiloxanschicht gemäß Schritt S) und
U) Auftragen mindestens einer, insbesondere transparenten und/oder eingefärbten, Deckschicht auf die Schicht gemäß Schritt Q), R), S) oder T), insbesondere auf die behandelte Polysiloxanschicht gemäß Schritt T).

Bei dem geschilderten Verfahren wird die Metallschicht, insbesondere Aluminiumschicht, in Schritt Q) vorzugsweise in einer Dicke aufgetragen, insbesondere aufgedampft oder aufgesputtert, so dass die Metallschicht, insbesondere auch nach Schritt l), m), n) und/oder o), für sichtbares Licht nicht transparent und nicht transluzent ist. Es hat sich überraschend gezeigt, dass, obwohl die Metallschicht in einer Dicke aufgetragen wird, die für das sichtbare Licht nicht transluzent oder sogar nicht transparent ist, das nach diesem Verfahren erhaltene Endprodukt gleichwohl ein mattes Erscheinungsbild liefert. Der matte Charakter wird demgemäß auf die aufgetragene Metallschicht übertragen. Hierdurch kann den nach diesem Verfahren erhaltenen nicht-metallischen Substrat, insbesondere beschichteten Kunststoffprodukten, ein sehr edel anmutendes Erscheinungsbild gegeben werden. Von Vorteil ist hierbei außerdem, dass sich nicht nur durch einen sehr ausgeprägten Korrosionsschutz auszeichnen, sondern, anders als dieses bei Produkten mit matten Oberflächen häufig der Fall ist, mechanische Einwirkungen auf die Oberfläche diese in ihrem Erscheinungsbild nicht beeinträchtigen. Beispielsweise beobachtet man keinen Abrieb bzw. keine Veränderung des matten Erscheinungsbildes an den Stellen, auf die mechanisch eingewirkt wurde. In entsprechender Weise kann durch Verwendung einer glänzenden Beschichtung der Glanz der darüber aufgebrachten Metallschicht nochmals intensiviert werden. Für die Erzeugung einer matten oder glänzenden Beschichtung können beliebige Farben verwendet werden. Wird die Metallschicht deckend aufgebracht, das heißt in einer Weise, dass sie für sichtbares Licht nicht transparent und auch nicht transluzent ist, wird nur der matte bzw. glänzende Charakter der Beschichtung auf die aufgetragene Metallschicht übertragen, nicht jedoch auch die Farbe dieser Beschichtung. Dem Fachmann sind matte und glänzende Beschichtungen bekannt, Matte Beschichtungen können zum Beispiel unter Verwendung einer sogenannten Mattierungspaste erhalten werden.

Bei dem vorangehend beschriebenen Verfahren werden in einer bevorzugten Ausführungsform dem Schritt U) die Schritte S) und T) vorgeschaltet.

Die der Erfindung zu Grunde liegende Aufgabe wird des Weiteren gelöst durch ein Verfahren zur Herstellung eines beschichteten Metallsubstrats, umfassend
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht, insbesondere Vakuumaufdampfanlage,
C) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder der Sputter-Anlage, oder als Bestandteil hiervon,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer, vorzugsweise eingefärbten, Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
PP-QQ) vorzugsweise Aufbringen mindestens einer Farbschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P),
Q') Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metallegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt o) oder P) oder auf die Farbschicht gemäß PP-QQ), wobei die Metallschicht, insbesondere Aluminimnschicht, in einer Dicke aufgetragen, insbesondere aufgedampft oder aufgesputtert, wird, dass die Metallschicht, insbesondere auch nach Schritt 1), m), n) und/oder o), für sichtbares Licht transparent oder transluzent ist,
R) gegebenenfalls Plasmabehandlung mit dem Plasmagenerator und/oder Corona-Behandlung der Metallschicht gemäß Schritt Q'),
S) vorzugsweise Behandeln der nach Schritt Q') oder R) erhaltenen Metallschicht mit mindestens einer siliziumorganischen Verbindung, insbesondere mittels Plasmapolymerisation, unter Ausbildung einer Polysiloxanschicht,
T) vorzugsweise Plasmabehandlung mit dem Plasmagenerator und/oder Corona-Behandlung der Polysiloxanschicht gemäß Schritt S) und
U) Auftragen mindestens einer, insbesondere transparenten und/oder eingefärbten, Deckschicht auf die Schicht gemäß Schritt Q'), R), S) oder T), insbesondere auf die behandelte Polysiloxanschicht gemäß Schritt T).

Die transparente oder transluzente Metallschicht in Schritt Q') verfügt vorzugsweise über eine durchschnittliche, insbesondere absolute, Dicke im Bereich von 1 nm bis 50 nm, vorzugsweise im Bereich von 10 nm bis 40 nm, und besonders bevorzugt im Bereich von 15 nm bis 30 nm.

Bei dem vorangehend beschriebenen Verfahren werden in einer bevorzugten Ausführungsform dem Schritt U) die Schritte S) und T) vorgeschaltet.

Benachbart zur transparenten oder transluzenten Metallschicht (Schicht Q'), und zwar jenseits der Deckschicht, liegen vorzugsweise die Farbschicht (Schicht PP-QQ)), die farbige bzw. eingefärbte Polysiloxanschicht, die farbige bzw. eingefärbte Grundierungsschicht oder das farbige bzw. eingefärbte Konversionsschicht an. Auf diese Weise können sehr hochwertig anmutende Beschichtungssysteme erhalten werden. Beispielsweise kann durch Verwendung einer schwarzen Farbschicht oder einer schwarz eingefärbten Grundierungsschicht, welche an der transparenten oder transluzenten Metallschicht anliegen, der Eindruck einer Schwarzchromschicht erzeugt werden.

Bei den beiden vorangehend geschilderten Verfahren zur Beschichtung von nicht-metallischen Substrat, insbesondere Kunststoffsubstraten, haben sich solche Verfahrensvarianten insbesondere auch zur Erzielung sehr zufriedenstellender Resultate hinsichtlich Haftung, Glanz und/oder Korrosionsbeständigkeit als zweckmäßig erwiesen, bei denen
die Schritte D), M), N), P-Q), Q), S), T) und U) oder D), M), N), Q'), S), T) und U) oder D), M), N), PP-QQ), Q'), S), T) und U) jeweils, insbesondere unmittelbar, aufeinander folgen oder
die Schritte D), M), N), O), P-Q), Q), S), T) und U) oder D), M), N), O), Q'), S), T) und U) oder D), M), N), O), PP-QQ), Q'), S), T) und U) jeweils, insbesondere unmittelbar, aufeinander folgen oder
die Schritte D), E), F,), M), P-Q'), Q), S), T) und U) oder D), E), F,), M), Q'), S), T) und U) oder D), E), F,), M), PP-QQ), Q'), S), T) und U) jeweils, insbesondere unmittelbar, aufeinander folgen oder
die Schritte D), E), F,), M), O), P-Q), Q), S), T) und U) oder D), E), F,), M), O), Q'), S), T) und U) oder D), E), F,), M), O), PP-QQ), Q'), S), T) und U) jeweils, insbesondere unmittelbar, aufeinander folgen oder
die Schritte D), G), H), M), P-Q), Q), S), T) und U) oder D), G), H), M), Q'), S), T) und U) oder D), G), H), M), PP-QQ), Q'), S), T) und U) jeweils, insbesondere unmittelbar, aufeinander folgen oder
die Schritte D), G), H), M), O), P-Q), Q), S), T) und U) oder D), G), H), M), O), Q'), S), T) und U) oder D), G), H), M), O), PP-QQ), Q'), S), T) und U) jeweils, insbesondere unmittelbar, aufeinander folgen oder
die Schritte D), E), G), H), M), P-Q), Q), S), T) und U) oder D), E), G), H), M), Q'), S), T) und U) oder D), E), G), H), M), PP-QQ), Q'), S), T) und U) jeweils, insbesondere unmittelbar, aufeinander folgen oder
die Schritte D), E), G), H), M), O), P-Q), Q), S), T) und U) oder D), E), G), H), M), O), Q'), S), T) und U) oder D), E), G), H), M), O), PP-QQ), Q'), S), T) und U) jeweils, insbesondere unmittelbar, aufeinander folgen oder
die D), M), P-Q), Q), S), T) und U) oder D), M), Q'), S), T) und U) oder D), M), PP-QQ), Q'), S), T) und U) jeweils, insbesondere unmittelbar, aufeinander folgen oder
die Schritte D), M), O), P-Q), Q), S), T) und U) oder D), M), O), Q'), S), T) und U) oder D), M), O), PP-QQ), Q'), S), T) und U) jeweils, insbesondere unmittelbar, aufeinander folgen oder
die Schritte D), G), H), P-Q), Q), S), T) und U) oder D), G), H), Q'), S), T) und U) oder D), G), H), PP-QQ), Q'), S), T) und U) jeweils, insbesondere unmittelbar, aufeinander folgen oder
die Schritte D), G), H), O), P-Q), Q), S), T) und U) oder D), G), H), O), Q'), S), T) und U) oder D), G), H), O), PP-QQ), Q'), S), T) und U) jeweils, insbesondere unmittelbar, aufeinander folgen.

Es hat sich für einige Anwendungen gezeigt, dass es auch bei der Herstellung von beschichteten Metallsubstraten von Vorteil ist, wenn beidseitig der Metallschicht eine, insbesondere plasmapolymerisierte, Polysiloxanschicht vorliegt, d.h. Verfahrensschritt O) mit zwischengeschaltet wird, vorzugsweise mit anschließender Plasmabehandlung und/oder Corona-Behandlung, insbesondere Plasmabehandlung. Somit kann zum Beispiel auch die vorangehend geschilderte Verfahrensvariante mit Schritt O) ausgestattet sein.

Ein besonders ausgeprägter Korrosionsschutz wird bei den nach dem erfindungsgemäßen Verfahren erhältlichen Metallsubstrat auch dadurch erhalten, dass man auf das gemäß Schritt D) gereinigte Metallsubstrat oder die gereinigte beschichtbare Oberfläche des Metallsubstrats mindestens eine Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, aufbringt (Schritt E)). Besonders vorteilhaft ist hierbei, wenn diese Metallschicht nachfolgend einem Plasmabehandlungsschritt unterzogen wird (Schritt F)).

In einer besonders zweckmäßigen Ausgestaltung wird die Schicht, auf die die Metallschicht gemäß Schritt Q) bzw. Q') aufgebracht wird, vor dem Schritt Q) bzw. Q') einer Plasmabehandlung mit dem Plasmagenerator und/oder einer Corona-Behandlung unterzogen (beispielsweise Schritte P), N), L), J), H), F) oder D)). Dies trifft insbesondere auch auf die Polysiloxanschicht zu.

Auch hat es sich in einer bevorzugten Ausführungsform als günstig insbesondere in Bezug auf gute Haftung und Korrosionsschutz erwiesen, wenn das metallische Substrat, insbesondere das gereinigte metallische Substrat, einer Plasmabehandlung und/oder Corona-Behandlung, insbesondere Plasmabehandlung, unterzogen wird (Schritt F)).

Vielfach hat es sich daher als vorteilhaft erwiesen, dass, wenn eine Polysiloxanschicht aufgetragen wird, diese Schicht anschließend einer Plasmabehandlung und/oder einer Corona-Behandlung, insbesondere einer Plasmabehandlung, unterzogen wird. Das gleiche trifft auf die Anbringung einer Grundierungsschicht zu. Auch hier hat es sich als vorteilhaft erwiesen, die erhaltene Grundierungsschicht zunächst einer Plasmabehandlung und/oder einer Corona-Behandlung zu unterziehen, insbesondere einer Plasmabehandlung.

Demgemäß hat es sich auch bei der Herstellung beschichteter Metallsubstrate nach dem erfindungsgemäßen Verfahren als vorteilhaft erwiesen, die vorangehend genannten Verfahrensschritte im Wesentlichen unmittelbar aufeinanderfolgen zu lassen. Dies bedeutet insbesondere, dass nach den Plasmabehandlungsschritten eine längere Lagerung vermieden werden sollte. Vielmehr ist es von Vorteil, wenn der nachfolgende Verfahrensschritt direkt folgt. Auch hat sich gezeigt, dass neben den vorangehend genannten Verfahrensschritten es nicht erforderlich ist, weitere Verfahrensschritte zwischen zu schalten.

Für die Metallsubstrate kann auf Metalle und Metalllegierungen zurückgegriffen werden, wobei besonders geeignete Metallsubstrate ausgewählt werden können aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebige Mischungen.

Geeignete Verfahren zur Reinigung von Metallsubstraten sind dem Fachmann bekannt. Derartige Reinigungsverfahren (Schritt D)) umfassen das Entfetten, Dekapieren, Phosphatieren, insbesondere Eisen- und/oder Zinkphosphatieren, Polieren, Schleifen, insbesondere Gleitschleifen, und/oder Behandeln mit Trockeneis. Diese Verfahren können sowohl einzeln als auch in beliebiger Kombination eingesetzt werden. Für viele Anwendungen hatte sich als ausreichend erwiesen, die Metallsubstrate durch Behandlung mit Trockeneis zu reinigen. Bei der Reinigung mit Trockeneis werden im Allgemeinen Trockeneispartikeln in Form von Pellets oder in Form von Kristallen, die von einem entsprechenden Trockeneisblock abgeschabt worden sind, mit Hilfe von Druckluft beschleunigt und auf die zu reinigende Metalloberfläche geleitet. Der Reinigungseffekt soll hierbei auf thermische, kinetische und Phasenumwandlungseffekte zurückzuführen sein. Vorrichtungen und Verfahren zur Reinigung von Metalloberflächen mit Trockeneis sind zum Beispiel der DE 195 44 906 A1 und EP 2 886 250 zu entnehmen.

Die Oberfläche von Metallsubstrate kann beispielsweise mit alkalischen oder sauren Reagenzien entfettet werden. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Für manche Ausführungsvarianten ist es vorteilhaft, die, insbesondere entfettete, Metallsubstratoberfläche mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man mittels Dekapierung in der Regel eine im Wesentlichen oxidfreie Metalloberfläche. Ebenso wie der Entfettungsschritt wird auch der Dekapierschritt im Allgemeinen durch einen Spülschritt abgeschlossen. Wird die Metallsubstratoberfläche poliert und/oder geschliffen bzw. gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, dass eine Einglättung durch Aufbringen einer Grundierschicht nicht mehr erforderlich ist. Allerdings kann es, wenn das Metallsubstrat zahlreiche Winkel und Ecken aufweist, die sich nicht ohne weiteres hinreichend polieren bzw. schleifen lassen, empfehlenswert sein, einen ersten und möglicherweise auch einen zweiten Grundierschritt nachzuschalten.

Anschließend an oder anstelle des Entfettungsschritts kann die metallische Substratoberfläche phosphatiert und/oder zu passiviert werden. Dies ist insbesondere bei Substraten aus oder enthaltend Aluminium bevorzugt.

In einer weiteren Ausgestaltung des erfindungsgemäßen Verfahrens zur Herstellung beschichteter Metallsubstrate gelangt man dadurch zu ganz besonders korrosionsbeständigen Substraten, dass in dem Schritt der Aufbringung der zur Deckschicht benachbarten Metallschicht ein erstes Metall, insbesondere Aluminium, oder eine erste Metalllegierung, insbesondere eine Aluminiumlegierung, in der Applikationsanlage für die Aufbringung einer Metallschicht, insbesondere der Vakuumaufdampfanlage oder der Sputter-Anlage, zeitlich überlappend mit einem zweiten Metall, das von dem ersten Metall verschieden ist, insbesondere ausgewählt aus der Gruppe bestehend aus Titan, Zirkonium und Hafnium, insbesondere Zirkonium, oder mit einer zweiten Metalllegierung, insbesondere einer Zirkoniumlegierung, die von der ersten Metalllegierung verschieden ist, co-verdampft wird. Dieses gelingt beispielsweise in der Weise, dass Metallpellets oder -stäbe des ersten Metalls oder der ersten Metalllegierung in ein entsprechendes erstes Aufnahmebehältnis, insbesondere erstes Schiffchen oder eine erste Wendel, gegeben werden und das Metallpellets oder -stäbe des zweiten Metalls oder der zweiten Metalllegierung in ein entsprechendes zweites Aufnahmebehältnis, zweites Schiffchen oder eine zweite Wendel, gegeben werden und dass das erste und das zweite Aufnahmebehältnis in der Weise aufgeheizt werden, dass die Schmelzpunkte von erstem und zweiten Metall bzw. erster und zweiter Metalllegierung bzw. von erstem Metall und zweiter Metalllegierung bzw. von erster Metalllegierung und zweitem Metall im Wesentlichen gleichzeitig oder innerhalb eines überlappenden Zeitraums erreicht und/oder aufrechterhalten werden.

Geeignete wässrige Konversionssysterne, mit deren Hilfe Konversionsschichten erhalten werden, sind dem Fachmann geläufig. Exemplarisch sei auf die Offenbarungen der US 2,825,697 und US 2,928,763 verwiesen.

Zur Aufbringung der Grundierungsschicht stehen dem Fachmann allseits bekannte Verfahren zur Verfügung. Exemplarisch seien das Nasslackverfahren, das Pulverbeschichtungsverfahren oder die Auftragung mittels UV-härtender Beschichtungssysteme genannt. Demgemäß kann die Grundierungsschicht in einer bevorzugten Ausgestaltung auf, insbesondere UV-härtende, pulverförmige Polyesterharzverbindungen oder auf Epoxid/Polyester-Pulver zurückgehen. Selbstverständlich ist es auch möglich, vor der Aufbringung einer Grundierungsschicht, wie vorangehend beschrieben, eine mechanische Glättung der Metallsubstratoberfläche, beispielsweise mittels Schleifens und/oder Polierens bzw. Gleitschleifens, durchzuführen.

Geeignete siliziumorganische Verbindungen sind dem Fachmann bekannt. In einer zweckmäßigen Ausgestaltung wird hierfür zurückgegriffen auf mindestens ein aminohaltiges Silan, insbesondere Aminopropyltriethoxysilan, Hexamethyldisiloxan, Tetramethyldisiloxan oder deren beliebige Mischungen. Besonders bevorzugt kommen Hexamethyldisiloxan und Tetramethyldisiloxan zum Einsatz, wobei Hexamethyldisiloxan regelmäßig besonders geeignet ist.

Geeignete siliziumorganische Verbindungen umfassen ebenfalls, als Monomer- oder als Comonomer-Bausteine, Verbindungen der folgenden Formel (I):

X-R₁-Si(R₂)₃₋ₘ(R₃)ₘ (I),

wobei die Substituenten und Indizes die folgende Bedeutung haben:
- m: 0, 1, 2 oder 3, insbesondere 2 oder 3,
- R1: C1- bis C10-Kohlenwasserstoffrest, insbesondere eine C1- bis C10-Kohlenwasserstoffkette, die durch Sauerstoff oder Stickstoff unterbrochen sein kann, insbesondere Methyl, Ethyl oder i- oder n-Propyl, vorzugsweise i- oder n-Propyl,
- R2: gleiche oder verschiedene hydrolysierbare Gruppen, insbesondere Alkoxygruppen wie Methoxy-, Ethoxy-, n-Propoxy, i-Propoxy, n-Butoxy, i-Butoxy oder t-Butoxy, insbesondere Methoxy oder Ethoxy,
- R3: gleiche oder verschiedene C1- bis C5-Alkylgruppen, insbesondere Methyl, Ethyl oder i- oder n-Propyl, vorzugsweise i- oder n-Propyl,
- X: funktionelle polymerisierbare Gruppe, insbesondere ein in ω-Stellung ungesättigter organischer Rest wie eine in ω-Stellung ungesättigte Alkenylgruppe mit 1 bis 10, vorzugsweise 2 bis 4 C-Atomen oder ein in ω-Stellung ungesättigter Carbonsäureesterrest von Carbonsäuren mit bis zu 4 Kohlenstoffatomen und Alkoholen mit bis zu 6 Kohlenstoffatomen.

Besonders geeignete Reste X umfassen z.B. Vinyl, Alkylvinyl, insbesondere Methyl-, Ethyl- oder Propylvinyl, (Meth)acryloxyalkyl, insbesondere (Meth)acryloxymethyl, (Meth)acryloxyethylen oder (Meth)acryloxypropyl, insbesondere (Meth)acryloxypropyl.

In einer Weiterentwicklung der erfindungsgemäßen Verfahren ist vorgesehen, dass eine erste siliziumorganische Verbindung über eine Zuführleitung aus einem außerhalb der Applikationsanlage für die Aufbringung einer Metallschicht, insbesondere außerhalb der Vakuumkammer der Vakuumaufdampfanlage, befindlichen ersten Behältnis dieser Applikationsanlage, insbesondere Vakuumkammer, zugeführt wird und dass eine zweite siliziumorganische Verbindung , die von der ersten siliziumorganische Verbindung verschieden ist, über eine Zuführleitung aus einem außerhalb der Applikationsanlage für die Aufbringung einer Metallschicht, insbesondere außerhalb der Vakuumkammer der Vakuumaufdampfanlage, befindlichen zweiten Behältnis dieser Applikationsanlage, insbesondere Vakuumkammer, zugeführt wird. Alternativ kann in dem ersten und dem zweiten Behältnis auch die gleiche siliziumorganische Verbindung vorliegen. Insbesondere ist es möglich, dass auch bei Verwendung gleicher siliziumorganischer Verbindungen eine dieser siliziumorganische Verbindungen mit einer weiteren, anderen siliziumorganische Verbindung und/oder mit einem Farbmittel, insbesondere Farbstoff, vermengt vorliegen kann. Demgemäß zeichnen sich die erfindungsgemäßen Verfahren auch dadurch aus, dass man gemeinsam mit der mindestens einen siliziumorganischen Verbindung, insbesondere für die Plasmapolymerisation, mindestens ein Farbmittel, insbesondere einen Farbstoff, in die Applikationsanlage für die Aufbringung einer Metallschicht, vorzugsweise in Form eines Gemisches, einbringt. Letztgenannte Verfahrensvariante umfassend den Einsatz eines Farbmittels gelingt selbstverständlich ebenfalls bei Anwendung von nur einem Behälter.

Eine für die Durchführung der erfindungsgemäßen Verfahren geeignete Applikationsanlage für die Aufbringung einer Metallschicht umfasst mindestens ein erstes, insbesondere außerhalb der Applikationsanlage für die Aufbringung einer Metallschicht, insbesondere außerhalb der Vakuumkammer der Vakuumaufdampfanlage, vorliegendes Behältnis zur Aufnahme einer ersten siliziumorganischen Verbindung mit einer Zuführleitung zu der Applikationsanlage, insbesondere zur Vakuumkammer, und mindestens ein zweites, insbesondere außerhalb der Applikationsanlage für die Aufbringung einer Metallschicht, insbesondere außerhalb der Vakuumkammer der Vakuumaufdampfanlage, vorliegendes Behältnis zur Ausnahme einer zweiten siliziumorganischen Verbindung mit einer Zuführleitung zu der Applikationsanlage, insbesondere zur Vakuumkammer.

Eine besonders gute Haftung ohne Einschränkungen bei der Korrosionsbeständigkeit erhält man insbesondere auch dadurch, dass der Schritt der Behandlung mit mindestens einer siliziumorganischen Verbindung wie Hexamethyldisiloxan, insbesondere mittels Plasmapolymerisation, unter Ausbildung einer Polysiloxanschicht in Gegenwart mindestens eines reaktiven Gases wie Sauerstoff, Stickstoff, Kohlendioxid, Wasserstoff, Kohlenmonoxid, Wasserstoffperoxidgas, Wasserdampf, Ozon und/oder Luft, insbesondere in Gegenwart von Sauerstoff oder Luft, durchgeführt wird. Über die Einbindung von reaktiven Gasen, insbesondere Luft oder Sauerstoff, in den, insbesondere plasmagenerierten, Polymerisationsprozess erhält man härtere Polysiloxanschichten als bei der herkömmlichen Herstellung solcher Polysiloxanschichten ohne Mitverwendung der geschilderten reaktiven Gas. Diese härteren Polysiloxanschichten zeichnen sich auch durch eine größere Diffusionsgeschlossenheit aus. Hierbei kann in einer besonders zweckmäßigen Ausführungsform vorgesehen sein, dass die mindestens eine siliziumorganische Verbindung, insbesondere Hexamethyldisiloxan, und das mindestens eine reaktive Gas, insbesondere Sauerstoff oder Luft, als Mischung für den Behandlungsschritt eingesetzt werden. Die vorangehend geschilderte Ausführungsform der Mitverwendung reaktive Gase bei der, insbesondere plasmagenerierten, Herstellung der Polysiloxanschicht kommt vorzugsweise bei mindestens einem Schritt der Behandlung mit mindestens einer siliziumorganischen Verbindung, insbesondere mittels Plasmapolymerisation, unter Ausbildung einer Polysiloxanschicht oder aber auch bei jedem Schritt zur Herstellung einer Polysiloxanschicht zum Einsatz. Besonders bevorzugt wird diese Verfahrensvariante bei der Herstellung beschichteter nicht-metallischer Substrate, insbesondere von Kunststoffsubstraten, in Verfahrensschritt m) und bei der Herstellung beschichtete metallischer Substrate in Verfahrensschritt S) eingesetzt. In den den genannten Verfahrensschritten folgenden Verfahrensschritten n) bzw. T) wird die Plasmabehandlung bevorzugt mit Hilfe eines Plasmagases gebildet aus einem Inertgas, insbesondere Argon, und Sauerstoff oder Luft oder Stickstoff, insbesondere Sauerstoff, oder mit Hilfe eines Plasmagases gebildet aus Sauerstoff, Luft oder Stickstoff durchgeführt. Auch diese Vorgehensweise trägt nochmals zu einer verbesserten Haftung des Gesamtsystems, umfassend die Deckschicht bei.

Für den Schritt der Plasmabehandlung mit dem Plasmagenerator stehen grundsätzlich mehrere Verfahrensvarianten zur Auswahl. Gemäß einer ersten Variante kann das Plasma unter Einsatz mindestens eines Inertgases, insbesondere Argon, gebildet werden. Alternativ kann für die Generierung eines geeigneten Plasmas auch auf Mischungen aus mindestens einem Inertgas, insbesondere Argon, und einem reaktiven Gas wie Sauerstoff, Stickstoff, Kohlendioxid, Wasserstoff, Kohlenmonoxid, Wasserstoffperoxidgas, Wasserdampf, Ozon und/oder Luft zurückgegriffen werden. Bevorzugt kommen hierbei Sauerstoff und Stickstoff, insbesondere Sauerstoff, zum Einsatz. Schließlich ist es auch möglich, unter Verzicht von Inertgasen ausschließlich reaktive Gase wie Sauerstoff, Stickstoff, Wasserstoff, Kohlendioxid, Kohlenmonoxid, Wasserstoffperoxidgas, Wasserdampf, Ozon und/oder Luft für die Erzeugung des Plasmas einzusetzen. Hierbei wird bevorzugt auf Sauerstoff zurückgegriffen. Mit Hilfe einer Plasmabehandlung mit dem Plasmagenerator wird die zu beschichtende Oberfläche des Substrats aktiviert. Bei einem Plasmaverfahren wirkt regelmäßig ein energiereiches Plasma auf die Oberfläche des Formteils ein, so dass auf dieser Oberfläche aktive Zentren gebildet werden. Hierbei kann es sich beispielsweise um Hydroxygruppen und/oder um Carbonyl-Gruppen handeln. In gleicher Weise kann eine Aktivierung der Oberfläche der zu beschichtenden Oberfläche des Substrats im Wege der Beflammung erfolgen. Hierbei kann in einer bevorzugten Ausgestaltung einer Flamme, beispielsweise einer Propangasflamme, welche in einer Luftatmosphäre brennt, ein flüchtiges Silan oder eine Verbindung, die Titan und Aluminium enthält, zugesetzt werden. Durch die Beflammung kann die Oberfläche des Substrats, insbesondere eines Kunststoffsubstrats, in ähnlicher Weise verändert werden wie beim Plasmaverfahren, zum Beispiel unter Ausbildung von Hydroxygruppen.

Die erfindungsgemäßen Verfahren bieten den großen Vorteil, dass nahezu sämtliche Verfahrensschritte in der Applikationsanlage für die Aufbringung einer Metallschicht durchgeführt werden können. Dies betrifft neben der Aufbringung der Metallschichten auch die Aktivierung von Oberflächen mittels der Plasmabehandlung mit dem Plasmagenerator ebenso wie die Aufbringung der Polysiloxanschicht, insbesondere mittels Plasmapolymerisation. Einzig die Reinigungsschritte, die Aufbringung einer Grundierungsschicht, die Aufbringung einer Konversionsschicht und die Aufbringung der Deckschicht werden regelmäßig außerhalb der genannten Applikationsanlage aufgebracht. Demgemäß kann vorgesehen sein, das die, insbesondere jede, Plasmabehandlung mit dem Plasmagenerator und/oder die, insbesondere jede, Aufbringung der Metallschicht, und/oder die, insbesondere jede, Aufbringung der Polysiloxanschicht in der Applikationsanlage für die Aufbringung einer Metallschicht, insbesondere in der Vakuumaufdampfanlage oder in der Sputter-Anlage, vorgenommen wird und/oder dass die Aufbringung der Grundierungsschicht und/oder die Aufbringung der Konversionsschicht und/oder die Aufbringung der Deckschicht außerhalb der Applikationsanlage für die Aufbringung einer Metallschicht, insbesondere der Vakuumaufdampfanlage oder der Sputter-Anlage, vorgenommen wird.

Für die Deckschicht kann z.B. auch auf wasserverdünnbare Beschichtungszusammensetzungen zurückgegriffen werden. Die Deckschicht kann gebildet werden aus Polyacrylatharzen, Polyesterharzen, Aminoplastharzen oder Polyurethanverbindungen. Bevorzugt werden bei den erfindungsgemäßen Verfahren solche Deckschichten aufgetragen, die auf ein UVhärtendes Beschichtungsmaterial zurückgehen. Demgemäß stellt eine bevorzugte Deckschicht eine UV-gehärtete Deckschicht dar. Die Deckschicht kann z.B. über einen Klarlack oder ein transparentes Pulver erhalten werden. Vorzugsweise wird die Deckschicht über ein Nasslackverfahren bzw. ein Pulverbeschichtungsverfahren aufgetragen. Bei der Deckschicht kann es sich demgemäß zum Beispiel um ein-, zwei- oder mehrkomponentige Lacke handeln, wobei Klarlacke bevorzugt sind. Bei diesen Klarlacken kann es sich z.B. um chemisch vernetzende zweikomponentige, um einkomponentige wärmehärtende oder um UV-härtende Lacke handeln. Des Weiteren kann für die Deckschicht auf 1K- oder 2K-Einbrennlack zurückgegriffen werden.

Die Deckschicht verfügt in der Regel über eine Dicke im Bereich von 10 bis 50 µm, vorzugsweise im Bereich von 20 bis 30 µm. Erfindungswesentlich für die erfindungsgemäßen Verfahren ist, dass das die Deckschicht bildende Material auf eine zuvor mittels Plasmabehandlung und/oder Corona-Behandlung aktivierte Polysiloxanschicht, welche wiederum bevorzugt im Wege einer Plasmapolymerisation erhalten wurde, aufgetragen wird, und zwar vorzugsweise im Wesentlichen ohne zeitliche Verzögerung.

Die Plasmabehandlung mit dem Plasmagenerator wird mitunter auch mit dem Begriff Glimmen beschrieben.

Für die Auftragung der Metallschichten kann zum Beispiel zurückgegriffen werden auf die Techniken der Physical Vapour Deposition (PVD), Chemical Vapour Deposition (CVD), des Aufdampfens mittels eines Elektronenstahl-Verdampfers, des Aufdampfens mittels eines Widerstandsverdampfers, der Induktionsverdampfung, der ARC-Verdampfung oder der Kathoden- bzw. Anodenzerstäubung (Sputter-Beschichtung). Demgemäß kommen als Applikationsanlagen für die Aufbringung einer Metallschicht zum Beispiel vorzugsweise Vakuumaufdampfanlagen oder Sputter-Anlagen in Frage. Geeignete Vakuumaufdampfanlagen umfassen zweckmäßigerweise PVD-Anlagen (Physical Vapour Deposition), CVD-Anlagen (Chemical Vapour Deposition), Elektronenstahl-Verdampfer, Widerstandsverdampfer, Induktionsverdampfer und ARC-Verdampfer. Geeignete Sputter-Anlagen umfassen zum Beispiel Kathodenzerstäuber und Anodenzerstäuber. Wie dem Fachmann bekannt ist, besteht eine Metallschicht vorwiegend aus Metall. Dies schließt Zusätze, wie sie beispielsweise bei rostfreiem Stahl in Form von Kohlenstoff zum Einsatz kommen, nicht gänzlich aus. Vorzugsweise ist der Metallanteil der vorliegenden Metallschicht größer 90 Gew%, insbesondere 95 Gew% und ganz besonders bevorzugt ≥ 98 Gew%.

Vorzugsweise ist die Metallschicht eine aufgedampfte oder aufgesputterte Metallschicht, insbesondere ein PVD-Metallschicht. Beim PVD-Verfahren kommen im Allgemeinen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an aufzudampfendem Metall gegeben. Nach dem Schließen und Evakuieren der PVD-Anlage kann die Verdampfung durch Einschalten der Stromversorgung, wodurch man die Verdampferschienen die Wendel zum Glühen bringt, gestartet werden. Das feste Metall beginnt zu schmelzen und benetzt die meist verdrillten Wendeln vollständig. Durch weitere Energiezufuhr wird das flüssige Metall in die Gasphase überführt so dass es sich auf dem zu beschichtenden Substrat abscheiden kann. Über die Menge an in die Gasphase überführtem Metall und/oder die Dauer der Beschichtungsphase kann die Dicke der Metallschicht, und damit auch das Erscheinungsbild derselben gezielt eingestellt werden.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlass von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten. Mit dem Sputter-Verfahren lassen sich unterschiedliche Metallschichtdicken gezielt einstellen.

Eine Einfärbung der auf den nicht-metallischen und metallischen Substraten vorliegenden Beschichtung kann mit den erfindungsgemäßen Verfahren auch dadurch bewerkstelligt werden, dass für das Auftragen der Deckschicht ein Beschichtungsmaterial enthaltend mindestens ein Farbmittel, z.B. mindestens ein Pigment und/oder mindestens einen Farbstoff, eingesetzt wird. Auch lassen sich dem Fachmann bekannte Lasuren verwenden, um die Deckschicht einzufärben, beispielsweise um Messing-, Titan- und Goldtöne oder individuelle Farbtöne wie rot, blau, gelb, grün, etc. oder Eloxalfarbtöne zu erhalten. Zum Beispiel können in die Deckschicht auch Effektpigmente wie Perlglanzpigmente, LCP-Pigmente (liquid crystal polymer) oder OV-Pigmente (optical variable) eingearbeitet werden.

Die der Erfindung zu Grunde liegende Aufgabe wird des Weiteren gelöst durch ein beschichtetes nicht-metallisches Substrat, insbesondere beschichtetes Kunststoffsubstrat, vorzugsweise erhalten oder erhältlich nach einem erfindungsgemäßen Verfahren, umfassend, in dieser Reihenfolge,
- ein, insbesondere plasma- und/oder coronabehandeltes, nicht-metallisches Substrat, insbesondere Kunststoffsubstrat;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht;
- gegebenenfalls mindestens eine, vorzugsweise plasma- und/oder coronabehandelte und/oder eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- mindestens eine matte, insbesondere farbige, Beschichtung, beispielsweise ein Mattlack, insbesondere mit dem Glanzgrad "mittlerer Glanz" (G2) oder vorzugsweise mit dem Glanzgrad "matt" (G3), jeweils bestimmt gemäß DIN EN ISO 2813:2014 (Ausgabedatum: 2015-02), oder mindestens eine glänzende, insbesondere farbige, Beschichtung, beispielsweise ein Glanzlack, insbesondere mit dem Glanzgrad "glänzend" (G1), bestimmt gemäß DIN EN ISO 2813:2014 (Ausgabedatum: 2015-02), vorzugsweise die matte Beschichtung;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

Die Metallschicht weist vorteilhafter Weise eine Dicke auf, die für sichtbares Licht nicht transparent und nicht transluzent ist. Eine derartige Metallschicht kann auch als deckend bezeichnet werden. Eine Metallschicht ist nicht transparent im Sinne der vorliegenden Erfindung, wenn, aufgetragen auf das Substrat bzw. auf eine auf dem Substrat vorliegende Schicht, Details des Substrat bzw. der Schicht nicht erkennbar sind, d.h. die Metallschicht nicht blickdurchlässig ist. Eine Metallschicht ist nicht transluzent im Sinne der vorliegende Erfindung, wenn, aufgetragen auf das Substrat bzw. auf eine auf dem Substrat vorliegende Schicht, die Metallschicht nicht lichtdurchlässig ist. D.h. eine tansluzente Metallschicht ist lichtdurchlässig, jedoch nicht blickdurchlässig. Auch bei einer transluzenten Metallschicht kann z.B. die Farbe des darunter vorliegenden Substrats bzw. der darunter vorliegenden Beschichtung erkannt werden.

Die der Erfindung zu Grunde liegende Aufgabe wird des Weiteren gelöst durch ein beschichtetes nicht-metallisches Substrat, insbesondere beschichtetes Kunststoffsubstrat, vorzugsweise erhalten oder erhältlich nach einem erfindungsgemäßen Verfahren, umfassend, in dieser Reihenfolge,
- ein, insbesondere plasma- und/oder coronabehandeltes, nicht-metallisches Substrat, insbesondere Kunststoffsubstrat;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht;
- gegebenenfalls mindestens eine, vorzugsweise plasma- und/oder coronabehandelte, insbesondere eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- vorzugsweise mindestens eine, vorzugsweise plasma- und/oder coronabehandelte, Farbschicht;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht, die für sichtbares Licht transparent oder transluzent ist;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

Die transparente oder transluzente Metallschicht verfügt vorteilhafterweise über eine durchschnittliche, insbesondere absolute, Dicke im Bereich von 1 nm bis 50 nm, vorzugsweise im Bereich von 10 nm bis 40 nm, und besonders bevorzugt im Bereich von 15 nm bis 30 nm.

Bei dem vorangehend geschilderten beschichteten nicht-metallischen Substrat ist eine solche Ausführungsform bevorzugt, bei der zwischen Metallschicht und Deckschicht eine mittels Plasmapolymerisation mindestens einer siliziumorganischen Verbindung erhaltene Polysiloxanschicht vorliegt, die darüber hinaus plasma- und/oder coronabehandelt wurde.

Des Weiteren ist eine solche Ausführungsvariante bevorzugt, bei der benachbart anliegend zur mittels Aufdampf- und/oder Sputter-Technik erhaltenen Metallschicht die Farbschicht, die farbige bzw. eingefärbte Polysiloxanschicht, die farbige bzw. eingefärbte Grundierungsschicht oder das farbige bzw. eingefärbte nicht-metallische Substrat vorliegt.

Besonders ansprechende, insbesondere edel anmutende Oberflächen können hierbei auch dadurch erzielt werden, dass das nicht-metallisches Substrat, mindestens eine Polysiloxanschicht, die Grundierungsschicht, die matte oder glänezende Beschichtung, die Farbschicht, die Metallschicht und/oder die Deckschicht, insbesondere die matte oder glänzende Beschichtung oder die Farbschicht, eine strukturierte Oberfläche aufweisen.

Die der Erfindung zugrunde liegende Erfindung wird des Weiteren gelöst durch ein Beschichtetes Metallsubstrat, insbesondere erhalten oder erhältlich nach einem erfindungsgemäßen Verfahren, umfassend, in dieser Reihenfolge,
- ein, insbesondere plasma- und/oder coronabehandeltes und/oder gereinigtes, Metallsubstrat;
- gegebenenfalls eine mittels Aufdampf- und/oder Sputter-Technik erhaltene, vorzugsweise plasma- und/oder coronabehandelte, Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen;
- gegebenenfalls eine, insbesondere mittels Plasmapolymerisation mindestens einer siliziumorganischen Verbindung erhaltene, vorzugsweise plasma- und/oder caronabehandelte, Polysiloxanschicht;
- gegebenenfalls mindestens eine, vorzugsweise plasma- und/oder coronabehandelte, Konversionsschicht,
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- gegebenenfalls mindestens eine, vorzugsweise plasma- und/oder coronabehandelte und/oder eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- mindestens eine matte, insbesondere farbige, Beschichtung, beispielsweise ein Mattlack, insbesondere mit dem Glanzgrad "mittlerer Glanz" (G2), vorzugsweise mit dem Glanzgrad matt" (G3), jeweils bestimmt gemäß DIN EN ISO 2813:2014 (Ausgabedatum: 2015-02), oder mindestens eine glänzende, insbesondere farbige, Beschichtung, beispielsweise ein Glanzlack, insbesondere mit dem Glanzgrad "glänzend" (G1), bestimmt gemäß DIN EN ISO 2813:2014 (Ausgabedatum: 2015-02), vorzugsweise die matte Beschichtung;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

Die zur Deckschicht benachbarte Metallschicht, insbesondere Aluminiumschicht, ist vorteilhafterweise für sichtbares Licht nicht transparent und nicht transluzent.

Bei dem vorangehend geschilderten beschichteten Metallsubstrat ist eine solche Ausführungsform bevorzugt, bei der zwischen Metallschicht und Deckschicht eine mittels Plasmapolymerisation mindestens einer siliziumorganischen Verbindung erhaltene Polysiloxanschicht vorliegt, die darüber hinaus plasma- und/oder coronabehandelt wurde.

Die der Erfindung zugrunde liegende Aufgabe wird schließlich auch gelöst durch ein beschichtetes Metallsubstrat, insbesondere erhalten oder erhältlich nach einem erfindungsgemäßen Verfahren, umfassend, in dieser Reihenfolge,
- ein, insbesondere plasma- und/oder coronabehandeltes und/oder gereinigtes, Metallsubstrat;
- gegebenenfalls eine mittels Aufdampf- und/oder Sputter-Technik erhaltene, vorzugsweise plasma- und/oder coronabehandelte, Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht;
- gegebenenfalls mindestens eine, vorzugsweise plasma- und/oder coronabehandelte, Konversionsschicht,
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- gegebenenfalls mindestens eine, vorzugsweise plasma- und/oder coronabehandelte und/oder eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- vorzugsweise mindestens eine, vorzugsweise plasma- und/oder coronabehandelte, Farbschicht;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht, die für sichtbares Licht transparent oder transluzent ist;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

Die zur Deckschicht benachbarte Metallschicht, insbesondere Aluminiumschicht, liegt hierbei vorzugsweise in einer durchschnittlichen, insbesondere absoluten, Dicke im Bereich von 1 nm bis 50 nm, vorzugsweise im Bereich von 10 nm bis 40 nm, und besonders bevorzugt im Bereich von 15 nm bis 30 nm, vor.

Bei dem vorangehend geschilderten beschichteten Metallsubstrat ist eine solche Ausführungsform bevorzugt, bei der zwischen Metallschicht und Deckschicht eine mittels Plasmapolymerisation mindestens einer siliziumorganischen Verbindung erhaltene Polysiloxanschicht vorliegt, die darüber hinaus plasma- und/oder coronabehandelt wurde.

Des Weiteren ist eine solche Ausführungsvariante bevorzugt, bei der benachbart anliegend zur mittels Aufdampf- und/oder Sputter-Technik erhaltenen Metallschicht die Farbschicht, die farbige bzw. eingefärbte Polysiloxanschicht, die farbige bzw. eingefärbte Grundierungsschicht oder die farbige bzw. eingefärbte Konvesionsschicht vorliegt.

Dabei weisen das Metallsubstrat, die mindestens eine Metallschicht, die mindestens eine Polysiloxanschicht, die Konversionsschicht, die Grundierungsschicht, die matte oder glänzende Beschichtung, die Farbschicht und/oder die Deckschicht, insbesondere die matte oder glänzende Beschichtung oder die Farbschicht, in einer zweckmäßigen Ausgestaltung eine strukturierte Oberfläche auf.

Für die Farbschicht, wie sie in den Verfahrensschritten jj-kk und PP-QQ zum Einsatz kommen kann und wie sie in den nach den erfindungsgemäßen Verfahren erhältlichen beschichteten Substraten zu finden sein kann, kann auf 2K-Lacsysteme, 1K-Lacksysteme und auch auf UV-Lacksysteme zurückgegriffen werden.

Geeignete Applikationsanlage für die Aufbringung einer Metallschicht umfassen oder stellen eine Vakuumaufdampfanlage dar mit einer Vakuumkammer, und mindestens eine, insbesondere eine Vielzahl an ersten beheizbaren Aufnahmeeinheiten, insbesondere Schalen, Schiffchen oder Wendeln, jeweils in Wirkverbindung mit einer ersten Heizeinrichtung oder eine erste Heizeinrichtung umfassend oder darstellend, jeweils ausgelegt und geeignet für die Aufnahme eines ersten Metalls oder einer ersten Metalllegierung mit einem ersten Schmelzpunkt oder Schmelzbereich, und mindestens eine, insbesondere eine Vielzahl an zweiten beheizbaren Aufnahmeeinheiten, insbesondere Schalen, Schiffchen oder Wendeln, jeweils in Wirkverbindung mit einer zweiten Heizeinrichtung oder eine zweite Heizeinrichtung umfassend oder darstellend, jeweils ausgelegt und geeignet für die Aufnahme eines zweiten Metalls oder zweiten Metalllegierung mit einem zweiten Schmelzpunkt oder Schmelzbereich, wobei der erste Schmelzpunkt oder der erste Schmelzbereich von dem zweiten Schmelzpunkt bzw. zweiten Schmelzbereich verschieden sind, und ferner eine Steuereinrichtung für die Einstellung von erster und zweiter Temperatur in der Weise, dass das erste und das zweite Metall oder die erste und zweite Metalllegierung im Wesentlichen zeitgleich oder zeitlich überlappend verdampfen (co-verdampfen).

Dabei kann in einer Ausführungsvariante vorgesehen sein, dass die Applikationsanlage für die Aufbringung einer Metallschicht mindestens ein erstes, insbesondere außerhalb der Vakuumkammer der Vakuumaufdampfanlage vorliegendes Behältnis zur Aufnahme einer ersten siliziumorganischen Verbindung mit einer Zuführleitung zur Vakuumkammer und mindestens ein zweites, insbesondere außerhalb der Vakuumkammer der Vakuuznaufdampfanlage vorliegendes Behältnis zur Aufnahme einer zweiten siliziumorganischen Verbindung mit einer zu für Leitung zur Vakuumkammer umfasst.

Als besonders zweckdienlich hat es sich erwiesen, die Applikationsanlage für die Aufbringung einer Metallschicht ebenfalls auszustatten mit mindestens einem, insbesondere in der Vakuumkammer vorliegenden, Gestell mit einer Längsorientierung und mit mindestens einem Träger, insbesondere in Form einer Welle, der im Wesentlichen entlang der Längsorientierung des Gestells ausgerichtet ist, ausgelegt und eingerichtet zur Aufnahme mindestens eines, insbesondere einer Vielzahl an nicht-metallischen und/oder metallischen Substraten, wobei das Gestell und/oder der mindestens eine Träger um eine, insbesondere im Wesentlichen horizontal ausgerichtete, Achse rotiert wahr sind. Geeignete Gestelle, die mit der Applikationsanlage verwendet werden können, sind zum Beispiel der EP 2 412 445 und der DE 20 2007 016 072 zu entnehmen.

Die nach dem erfindungsgemäßen Verfahren erhältlichen nicht-metallischen und metallischen Substrate können zum Beispiel eingesetzt werden als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Schmuckgegenstände oder als Bestandteil hiervon, für Edelbauteile oder als Bestandteil hiervon, für Innen- oder Außenmöbel oder für Bestandteile hiervon, beispielsweise Küchen-, Büro- oder Wohnmöbel, für Haushaltsgeräte, insbesondere Kaffeemaschinen, oder Bestandteile hiervon, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.

Außerdem wird die der Erfindung zugrunde liegende Aufgabe gelöst durch ein Verfahren zur Herstellung eines beschichteten nicht-metallischen Substrats, insbesondere Kunststoffsubstrats, umfassend
a) Zurverfügungstellung eines nicht-metallischen Substrats, insbesondere Kunststoffsubstrats, mit mindestens einer zumindest bereichsweise beschichtbaren Oberfläche,
c) Zurverfügungstellung mindestens eines Plasmagenerators und/oder mindestens einer Corona-Anlage,
d) gegebenenfalls Plasmabehandlung mit dem Plasmagenerator und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer, gegebenenfalls eingefärbten, Grundierungsschicht auf das nicht-metallische Substrat, insbesondere Kunststoffsubstrat, oder die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
j-k) Aufbringen mindestens einer matten, insbesondere farbigen, Beschichtung, beispielsweise eines Mattlacks, insbesondere mit dem Glanzgrad "mittlerer Glanz" (G2) oder vorzugsweise mit dem Glanzgrad "matt" (G3), jeweils bestimmt gemäß DIN EN ISO 2813:2014 (Ausgabedatum: 2015-02), oder Aufbringen mindestens einer glänzenden, insbesondere farbigen, Beschichtung, beispielsweise eines Glanzlacks, insbesondere mit dem Glanzgrad "glänzend" (G1), bestimmt gemäß DIN EN ISO 2813:2014 (Ausgabedatum: 2015-02), vorzugsweise der matten Beschichtung,
k") deckendes Aufbringen mindestens eines Effektlacks mit metallischem Farbeindruck,
l) gegebenenfalls Plasmabehandlung mit dem Plasmagenerator und/oder Corona-Behandlung der Effektlackschicht gemäß Schritt k"),
m) vorzugsweise Behandeln der nach Schritt k") oder 1) erhaltenen Effektlackschicht mit mindestens einer siliziumorganischen Verbindung, insbesondere mittels Plasmapolymerisation, unter Ausbildung einer Polysiloxanschicht,
n) vorzugsweise Plasmabehandlung mit dem Plasmagenerator und/oder Corona-Behandlung der Polysiloxanschicht gemäß Schritt m) und
o) Auftragen mindestens einer, insbesondere transparenten und/oder eingefärbten, Deckschicht auf die Schicht gemäß Schritt k"), l), m) oder n), insbesondere auf die behandelte Polysiloxanschicht gemäß Schritt n).

Das vorangehend geschilderte Verfahren unterscheidet sich von dem korrespondierenden erfindungsgemäßen Verfahren dadurch, dass der Schritt k) ersetzt worden ist durch den Schritt k") (deckendes Aufbringen mindestens eines Effektlacks mit metallischem Farbeindruck). In gleicher Weise unterscheiden sich die nach dem vorangehend geschilderten Verfahren erhältlichen beschichteten nicht-metallischen Substrate von den nach dem korrespondierenden Verfahren, enthaltend den Schritt k), erhältlichen beschichteten nicht-metallischen Substrate durch den Ersatz der Metallschicht durch den deckend aufgebrachten Effektlack mit metallischem Farbeindruck. Die allgemeinen und bevorzugten spezifischen Merkmale und Ausführungsvarianten, die vorangehend für das Verfahren enthaltend den Schritt k) sowie die nach diesem Verfahren erhältlichen beschichteten Produkte beschrieben worden sind, gelten in gleicher Weise für das Verfahren enthaltend den Schritt k") bzw. die nach diesem Verfahren erhältlichen beschichteten Produkte.

Auch wird die der Erfindung zugrunde liegende Aufgabe gelöst durch ein Verfahren zur Herstellung eines beschichteten nicht-metallischen Substrats, insbesondere Kunststoffsubstrats, umfassend
a) Zurverfügungstellung eines nicht-metallischen Substrats, insbesondere Kunststoffsubstrats, mit mindestens einer zumindest bereichsweise beschichtbaren Oberfläche,
c) Zurverfügungstellung mindestens eines Plasmagenerators und/oder mindestens einer Corona-Anlage,
d) gegebenenfalls Plasmabehandlung mit dem Plasmagenerators und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nicht-metallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer, insbesondere eingefärbten, Grundierungsschicht auf das nicht-metallische Substrat, insbesondere Kunststoffsubstrat, oder die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
jj-kk) vorzugsweise Aufbringen mindestens einer Farbschicht auf das nicht-metallische Substrat oder die beschichtbare Oberfläche des nicht-metallischen Substrats gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j),
k'") Aufbringen mindestens eines Effektlacks mit metallischem Farbeindruck in einer Weise, dass die erhaltene Beschichtung für sichtbares Licht transparent oder transluzent ist,
l) gegebenenfalls Plasmabehandlung mit dem Plasmagenerator und/oder Corona-Behandlung der Effektlackschicht gemäß Schritt k"'),
m) vorzugsweise Behandeln der nach Schritt k'") oder l) erhaltenen Effektlackschicht mit mindestens einer siliziumorganischen Verbindung, insbesondere mittels Plasmapolymerisation, unter Ausbildung einer Polysiloxanschicht,
n) vorzugsweise Plasmabehandlung mit dem Plasmagenerator und/oder Corona-Behandlung der Polysiloxanschicht gemäß Schritt m) und
o) Auftragen mindestens einer, insbesondere transparenten und/oder eingefärbten, Deckschicht auf die Schicht gemäß Schritt k"'), l), m) oder n), insbesondere auf die behandelte Polysiloxanschicht gemäß Schritt n).

Das vorangehend geschilderte Verfahren unterscheidet sich von dem korrespondierenden erfindungsgemäßen Verfahren dadurch, dass der Schritt k') ersetzt worden ist durch den Schritt k"') (Aufbringen mindestens eines Effektlacks mit metallischem Farbeindruck in einer Weise, dass die erhaltene Beschichtung für sichtbares Licht transparent oder transluzent ist). In gleicher Weise unterscheiden sich die nach dem vorangehend geschilderten Verfahren erhältlichen beschichteten nicht-metallischen Substrate von den nach dem korrespondierenden Verfahren, enthaltend den Schritt k'), erhältlichen beschichteten nicht-metallischen Substrate durch den Ersatz der Metallschicht durch den in einer Weise aufgebrachten Effektlack mit metallischem Farbeindruck, dass dieser für sichtbares Licht transparent oder transluzent ist. Die allgemeinen und bevorzugten spezifischen Merkmale und Ausführungsvarianten, die vorangehend für das Verfahren enthaltend den Schritt k') sowie die nach diesem Verfahren erhältlichen beschichteten Produkte beschrieben worden sind, gelten in gleicher Weise für das Verfahren enthaltend den Schritt k"') bzw. die nach diesem Verfahren erhältlichen beschichteten Produkte.

Des Weiteren wird die der Erfindung zugrunde liegende Aufgabe gelöst durch ein Verfahren zur Herstellung eines beschichteten Metallsubstrats, umfassend
A) Zurverfügungstellung eines Metallsubstrats mit mindestens einer zumindest bereichsweise beschichtbaren Oberfläche,
C) Zurverfügungstellung mindestens eines Plasmagenerators und/oder mindestens einer Corona-Anlage,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerators und/oder Corona-Behandlung der nach Schritt K) erhaltenen behandelten Polysiloxanschi cht,
M) gegebenenfalls Aufbringen mindestens einer, gegebenenfalls eingefärbten, Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
P-Q) Aufbringen mindestens einer matten, insbesondere farbigen, Beschichtung, beispielsweise eines Mattlacks, insbesondere mit dem Glanzgrad mittlerer Glanz" (G2) oder vorzugsweise mit dem Glanzgrad "matt" (G3), jeweils bestimmt gemäß DIN EN ISO 2813:2014 (Ausgabedatum: 2015-02), oder Aufbringen mindestens einer glänzenden, insbesondere farbigen, Beschichtung, beispielsweise eines Glanzlacks, insbesondere mit dem Glanzgrad "glänzend" (G1), bestimmt gemäß DIN EN ISO 2813:2014 (Ausgabedatum: 2015-02), vorzugsweise Aufbringen der matten Beschichtung,
Q") deckendes Aufbringen mindestens eines Effektlacks mit metallischem Farbeindruck,
R) gegebenenfalls Plasmabehandlung mit dem Plasmagenerator und/oder Corona-Behandlung der Effektlackschicht gemäß Schritt Q"),
   S) vorzugsweise Behandeln der nach Schritt Q") oder R) erhaltenen Effektlackschicht mit mindestens einer siliziumorganischen Verbindung, insbesondere mittels Plasmapolymerisation, unter Ausbildung einer Polysiloxanschicht,
   T) vorzugsweise Plasmabehandlung mit dem Plasmagenerator und/oder Corona-Behandlung der Polysiloxanschicht gemäß Schritt S) und
   U) Auftragen mindestens einer, insbesondere transparenten und/oder eingefärbten, Deckschicht auf die Schicht gemäß Schritt Q"), R), S) oder T), insbesondere auf die behandelte Polysiloxanschicht gemäß Schritt T).

Das vorangehend geschilderte Verfahren unterscheidet sich von dem korrespondierenden erfindungsgemäßen Verfahren dadurch, dass der Schritt Q) ersetzt worden ist durch den Schritt Q") (deckendes Aufbringen mindestens eines Effektlacks mit metallischem Farbeindruck). In gleicher Weise unterscheiden sich die nach dem vorangehend geschilderten Verfahren erhältlichen beschichteten Metallsubstrate von den nach dem korrespondierenden Verfahren, enthaltend den Schritt Q), erhältlichen beschichteten Metallsubstrate durch den Ersatz der Metallschicht durch den deckend aufgebrachten Effektlack mit metallischem Farbeindruck. Die allgemeinen und bevorzugten spezifischen Merkmale und Ausführungsvarianten, die vorangehend für das Verfahren enthaltend den Schritt Q) sowie die nach diesem Verfahren erhältlichen beschichteten Produkte beschrieben worden sind, gelten in gleicher Weise für das Verfahren enthaltend den Schritt Q") bzw. die nach diesem Verfahren erhältlichen beschichteten Produkte.

Schließlich wird die der Erfindung zugrunde liegende Aufgabe gelöst durch ein Verfahren zur Herstellung eines beschichteten Metallsubstrats, umfassend
A) Zurverfügungstellung eines Metallsubstrats mit mindestens einer zumindest bereichsweise beschichtbaren Oberfläche,
C) Zurverfügungstellung mindestens eines Plasmagenerators und/oder mindestens einer Corona-Anlage,
D) gegebenenfalls Reinigung des Metallsubstrats oder der beschichtbaren Oberfläche des Metallsubstrats,
E) gegebenenfalls Aufbringen mindestens einer Metalischicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer, vorzugsweise eingefärbten, Grundierungsschicht auf das Metallsubstrat oder die beschichtbare Oberfläche des Metallsubstrats gemäß Schritt A) oder D) oder auf die Metallschicht, gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungssehicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
PP-QQ) vorzugsweise Aufbringen mindestens einer Farbschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P),
Q''') Aufbringen mindestens eines Effektlacks mit metallischem Farbeindruck in einer Weise, dass die erhaltene Beschichtung für sichtbares Licht transparent oder transluzent ist,
R) gegebenenfalls Plasmabehandlung mit dem Plasmagenerator und/oder Corona-Behandlung der Effektlackschicht gemäß Schritt Q'''),
S) Behandeln der nach Schritt Q"') oder R) erhaltenen Effektlackschicht mit mindestens einer siliziumorganischen Verbindung, insbesondere mittels Plasmapolymerisation, unter Ausbildung einer Polysiloxanschicht,
T) Plasmabehandlung mit dem Plasmagenerator und/oder Corona-Behandlung der Polysiloxanschicht gemäß Schritt S) und
U) Auftragen mindestens einer, insbesondere transparenten und/oder eingefärbten, Deckschicht auf die Schicht gemäß Schritt Q'''), R), S) oder T), insbesondere auf die behandelte Polysiloxanschicht gemäß Schritt T).

Das vorangehend geschilderte Verfahren unterscheidet sich von dem korrespondierenden erfindungsgemäßen Verfahren dadurch, dass der Schritt Q') ersetzt worden ist durch den Schritt Q''') (Aufbringen mindestens eines Effektlacks mit metallischem Farbeindruck in einer Weise, dass die erhaltene Beschichtung für sichtbares Licht transparent oder transluzent ist). In gleicher Weise unterscheiden sich die nach dem vorangehend geschilderten Verfahren erhältlichen beschichteten Metallsubstrate von den nach dem korrespondierenden Verfahren, enthaltend den Schritt Q'), erhältlichen beschichteten Metallsubstrate durch den Ersatz der Metallschicht durch den in einer Weise aufgebrachten Effektlack mit metallischem Farbeindruck, dass dieser für sichtbares Licht transparent oder transluzent ist. Die allgemeinen und bevorzugten spezifischen Merkmale und Ausführungsvarianten, die vorangehend für das Verfahren enthaltend den Schritt Q') sowie die nach diesem Verfahren erhältlichen beschichteten Produkte beschrieben worden sind, gelten in gleicher Weise für das Verfahren enthaltend den Schritt Q''') bzw. die nach diesem Verfahren erhältlichen beschichteten Produkte.

Effektlacke, die ein metallisches Erscheinungsbild liefern, sind dem Fachmann bekannt. Solche Effektlacke machen regelmäßig Gebrauch von sogenannten metallischen Effektpigmenten bzw. von Metallpigmenten, z.B. auf Basis von Aluminium. Geeignete Effektlacke bzw. Eckpigmente finden sich zum Beispiel beschrieben in der DE 10 2007 007908, WO 2004/026971, WO 2004/026972, DE 4422287 und DE 19505161. Exemplarisch sei auch auf die Effekt- und Chromlacke der Firma Endlendt Color, D-16775 Sonnenberg, z.B. wie in der WO 2008/046567 A1 offenbart, sowie auf die HS-Effektlacke der Firma Holtmann & Stierle Chemie GmbH, D-32130 Enger, verwiesen.

Der Erfindung liegt die überraschende Erkenntnis zugrunde, dass mit den nach den erfindungsgemäßen Verfahren erhältlichen Substraten Oberflächen mit einem matten metallischen Erscheinungsbild ebenso erhalten werden können wie farbig anmutende metallische Oberflächen, und zwar auf einfache und zuverlässige, d.h. kostengünstige Weise. Die erfindungsgemäßen Verfahren sind ohne weiteres massenproduktionstauglich. Sie erlauben es, für Kunststoff- wie auch Metallsubstrat völlig neue Anwendungsfelder zu erschließen. Darüber hinaus kann mit den erfindungsgemäßen Verfahren bzw. mit den erfindungsgemäßen Produkten eine hochwertige farbige Glanzbeschichtung zur Verfügung gestellt werden, die dauerhaft ihren Glanz behält. Außerdem verfügen die nach dem erfindungsgemäßen Verfahren erhältlichen beschichteten nicht-metallischen und metallischen Substrate über eine hervorragende Korrosionsbeständigkeit. Die nach den erfindungsgemäßen Verfahren erhältlichen beschichteten Substrate zeichnen sich zudem durch eine sehr gute Haftung aus. Demgemäß zeigen diese beschichteten Substrate selbst dann überragende Korrosionsbeständigkeiten, wenn die Oberflächen mechanische Beschädigungen erfahren haben, beispielsweise mittels Steinschlag oder durch Anritzen. Außerdem ist von Vorteil, dass bei erfindungsgemäßen Substraten mit mattem Erscheinungsbild bei mechanischer Beanspruchung keine Beeinträchtigung der Oberfläche zu erkennen ist. Ein weiterer Vorteil, der mit den erfindungsgemäßen Verfahren einhergeht, ist, dass nur noch sehr geringe Umrüstzeiten erforderlich sind, um neue Substratschargen zu beschichten. Darüber hinaus ermöglicht das erfindungsgemäße Verfahren, den Umfang der Gesamtanlage zur Herstellung beschichteter Substrate mit farbigem oder mattem Erscheinungsbild ausgehend von dem noch nicht gereinigten, zu beschichtenden Substrat erheblich zu verringern, so dass ein signifikant reduzierter Platzbedarf gegenüber herkömmlichen Anlagen besteht. Darüber hinaus gelingt es mit den erfindungsgemäßen Verfahren, die Bearbeitungszeit bis zur Fertigstellung des beschichteten verkaufsfertigen Substrats erheblich zu verringern. Hiermit gehen zwangsläufig verringerte Zykluszeiten einher.

Die in der vorstehenden Beschreibung und in den Ansprüchen offenbarten Merkmale der Erfindung können sowohl einzeln aus auch in jeder beliebigen Kombination für die Verwirklichung der Erfindung in ihren verschiedenen Ausführungsformen wesentlich sein.

## Patentansprüche

1. Verfahren zur Herstellung eines beschichteten nicht-metallischen Substrats, insbesondere Kunststoffsubstrats, umfassend
a) Zurverfügungstellung eines nicht-metallischen Substrats, insbesondere Kunststoffsubstrats, mit mindestens einer zumindest bereichsweise beschichtbaren Oberfläche,
b) Zurverfügungstellung einer Applikationsanlage für die Aufbringung einer Metallschicht, insbesondere Vakuumaufdampfanlage oder Sputter-Anlage,
c) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder Sputter-Anlage, oder als Bestandteil hiervon,
d) gegebenenfalls Plasmabehandlung mit dem Plasmagenerator und/oder Corona-Behandlung des nicht-metallischen Substrats, insbesondere Kunststoffsubstrats, oder der beschichtbaren Oberfläche des nicht-metallischen Substrats, insbesondere Kunststoffsubstrats,
e) gegebenenfalls Behandeln des nach Schritt a) oder d) erhaltenen nichtmetallischen Substrats, insbesondere Kunststoffsubstrats, oder der beschichtbaren Oberfläche des nicht-metallischen Substrats, insbesondere Kunststoffsubstrats, mit mindestens einer siliziumorganischen Verbindung, insbesondere mittels Plasmapolymerisation, unter Ausbildung einer Polysiloxanschicht,
f) gegebenenfalls Plasmabehandlung mit dem Plasmagenerator und/oder Corona-Behandlung der Polysiloxanschicht gemäß Schritt e),
g) gegebenenfalls Aufbringen mindestens einer, insbesondere eingefärbten, Grundierungsschicht auf das nicht-metallische Substrat, insbesondere Kunststoffsubstrat, oder die beschichtbare Oberfläche des nicht-metallischen Substrats, insbesondere Kunststoffsubstrats, gemäß Schritt a) oder d) oder auf die Polysiloxanschicht gemäß Schritt e) oder f),
h) gegebenenfalls Plasmabehandlung mit dem Plasmagenerator und/oder Corona-Behandlung der Grundierungsschicht gemäß Schritt g),
i) gegebenenfalls Behandeln der nach Schritt g) oder h) erhaltenen Grundierungsschicht mit mindestens einer siliziumorganischen Verbindung, insbesondere mittels Plasmapolymerisation, unter Ausbildung einer Polysiloxanschicht,
j) gegebenenfalls Plasmabehandlung mit dem Plasmagenerator und/oder Corona-Behandlung der Polysiloxanschicht gemäß Schritt i),
jj-kk) vorzugsweise Aufbringen mindestens einer Farbschicht auf das nicht-metallische Substrat oder die beschichtbare Oberfläche des nicht-metallischen Substrats gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j), k') Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Nickel, Kupfer, Chrom, Palladium, Molybdän, Wolfram, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das nicht-metallische Substrat, insbesondere Kunststoffsubstrat, oder auf die beschichtbare Oberfläche des nicht-metallischen Substrats, insbesondere Kunststoffsubstrats, gemäß Schritt a) oder d) oder auf die Polysiloxanschicht gemäß Schritt e) oder f) oder auf die Grundierungsschicht gemäß Schritt g) oder h) oder auf die Polysiloxanschicht gemäß Schritt i) oder j) oder auf die Farbschicht gemäß Schritt jj-kk), wobei die Metallschicht, insbesondere Aluminiumschicht, in einer Dicke aufgetragen, insbesondere aufgedampft oder aufgesputtert, wird, dass die Metallschicht, insbesondere nach Schritt l), m), n) und/oder o), für sichtbares Licht transparent oder transluzent ist,
l) gegebenenfalls Plasmabehandlung mit dem Plasmagenerator und/oder Corona-Behandlung der Metallschicht gemäß Schritt k'),
m) vorzugsweise Behandeln der nach Schritt k') oder l) erhaltenen Metallschicht mit mindestens einer siliziumorganischen Verbindung, insbesondere mittels Plasmapolymerisation, unter Ausbildung einer Polysiloxanschicht,
n) vorzugsweise Plasmabehandlung mit dem Plasmagenerator und/oder Corona-Behandlung der Polysiloxanschicht gemäß Schritt m) und
o) Auftragen mindestens einer, insbesondere transparenten und/oder eingefärbten, Deckschicht auf die Schicht gemäß Schritt k'), l), m) oder n), insbesondere auf die behandelte Polysiloxanschicht gemäß Schritt n).

2. Verfahren nach Anspruch 1, **dadurch gekennzeichnet, dass** die Metallschicht in einer durchschnittlichen, insbesondere absoluten, Dicke im Bereich von 1 nm bis 50 nm, vorzugsweise im Bereich von 10 nm bis 40 nm, und besonders bevorzugt im Bereich von 15 nm bis 30 nm, vorliegt und/oder dass dem Schritt o) die Schritte m) und n) vorgelagert sind und/oder dass benachbart anliegend zur Schicht k') die Schicht jj-kk), eine farbige Polysiloxanschicht, eine farbige Grundierungsschicht oder ein farbiges nicht-metallisches Substrat vorliegt.

3. Verfahren nach Anspruch 1 oder 2, **dadurch gekennzeichnet, dass** die Schritte g), h), k), m), n) und o) oder g), h), k'), m), n) und o) oder g), h), jj-kk), k'), m), n) und o) jeweils, insbesondere unmittelbar, aufeinander folgen, insbesondere unter Auslassung der Schritte d), e) und/oder f) oder unter Einsatz von Schritt d) und unter Auslassung von Schritt e) und f), oder
dass die Schritte g), h), i), k), m), n) und o) oder g), h), i), k'), m), n) und o) oder g), h), i), jj-kk), k'), m), n) und o) jeweils, insbesondere unmittelbar, aufeinander folgen, insbesondere unter Auslassung der Schritte d), e) und/oder f) oder unter Einsatz von Schritt d) und unter Auslassung von Schritt e) und f), oder
dass die Schritte d), e), f), k), m), n) und o) oder d), e), f), k'), m), n) und o) oder d), e), f), jj-kk), k'), m), n) und o) jeweils, insbesondere unmittelbar, aufeinander folgen oder
dass die Schritte d), e), f), i), k), m), n) und o) oder d), e), f), i), k'), m), n) und o) oder d), e), f), i), jj-kk), k'), m), n) und o) jeweils, insbesondere unmittelbar, aufeinander folgen oder
dass die Schritte d), e), f), g), k), m), n) und o) oder d), e), f), g), k'), m), n) und o) oder d), e), f), g), jj-kk), k'), m), n) und o) jeweils, insbesondere unmittelbar, aufeinander folgen oder
dass die Schritte d), e), f), g), i), k), m), n) und o) oder d), e), f), g), i), k'), m), n) und o) oder d), e), f), g), i), jj-kk), k'), m), n) und o) jeweils, insbesondere unmittelbar, aufeinander folgen.

4. Verfahren zur Herstellung eines beschichteten Metallsubstrats, umfassend
A) Zurverfügungstellung eines Metallsubstrats mit mindestens einer zumindest bereichsweise beschichtbaren Oberfläche,
B) Zurverfügungstellung einer Applikationsanlage für die Aufbringung einer Metallschicht, insbesondere Vakuumaufdampfanlage,
C) Zurverfügungstellung mindestens eines Plasmagenerators und/oder mindestens einer Corona-Anlage, insbesondere in der Applikationsanlage für die Aufbringung einer Metallschicht, wie Vakuumaufdampfanlage oder der Sputter-Anlage, oder als Bestandteil hiervon,
D) gegebenenfalls Reinigung des Metallsubstrats oder der beschichtbaren Oberfläche des Metallsubstrats,
E) gegebenenfalls Aufbringen mindestens einer Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D),
F) gegebenenfalls Plasmabehandlung mit dem Plasmagenerator und/oder Corona-Behandlung des Metallsubstrats oder der beschichtbaren Oberfläche des Metallsubstrats gemäß Schritt A) oder D) oder der Metallschicht gemäß Schritt E),
G) gegebenenfalls Behandeln des nach Schritt A) oder D) erhaltenen Metallsubstrats oder Behandeln der nach Schritt A) oder D) erhaltenen beschichtbaren Oberfläche des Metallsubstrats oder der nach Schritt E) oder F) erhaltenen Metallschicht mit mindestens einer siliziumorganischen Verbindung, insbesondere mittels Plasmapolymerisation, unter Ausbildung einer Polysiloxanschicht,
H) gegebenenfalls Plasmabehandlung mit dem Plasmagenerator und/oder Corona-Behandlung der Polysiloxanschicht gemäß Schritt G),
I) gegebenenfalls Aufbringen einer Konversionsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H),
J) gegebenenfalls Plasmabehandlung mit dem Plasmagenerator und/oder Corona-Behandlung der Konversionsschicht gemäß Schritt I),
K) gegebenenfalls Behandeln der nach Schritt I) oder J) erhaltenen Konversionsschicht mit mindestens einer siliziumorganischen Verbindung, insbesondere mittels Plasmapolymerisation, unter Ausbildung einer Polysiloxanschicht,
L) gegebenenfalls Plasmabehandlung mit dem Plasmagenerator und/oder Corona-Behandlung der nach Schritt K) erhaltenen behandelten Polysiloxanschicht,
M) gegebenenfalls Aufbringen mindestens einer, vorzugsweise eingefärbten, Grundierungsschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L),
N) gegebenenfalls Plasmabehandlung mit dem Plasmagenerator und/oder Corona-Behandlung der Grundierungsschicht gemäß Schritt M),
O) gegebenenfalls Behandeln der nach Schritt M) oder N) erhaltenen Grundierungsschicht mit mindestens einer siliziumorganischen Verbindung, insbesondere mittels Plasmapolymerisation, unter Ausbildung einer Polysiloxanschicht,
P) gegebenenfalls Plasmabehandlung mit dem Plasmagenerator und/oder Corona-Behandlung der nach Schritt O) erhaltenen behandelten Polysiloxanschicht,
PP-QQ) vorzugsweise Aufbringen mindestens einer Farbschicht auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P),
Q') Aufbringen mindestens einer Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, mit der Applikationsanlage, insbesondere mittels Aufdampf- und/oder Sputter-Technik, auf das Metallsubstrat oder die beschichtbare Oberfläche des Metallsubstrats gemäß Schritt A) oder D) oder auf die Metallschicht gemäß Schritt E) oder F) oder auf die Polysiloxanschicht gemäß Schritt G) oder H) oder auf die Konversionsschicht gemäß Schritt I) oder J) oder auf die Polysiloxanschicht gemäß Schritt K) oder L) oder auf die Grundierungsschicht gemäß Schritt M) oder N) oder auf die Polysiloxanschicht gemäß Schritt O) oder P) oder auf die Farbschicht gemäß PP-QQ), wobei die Metallschicht, insbesondere Aluminiumschicht, in einer Dicke aufgetragen, insbesondere aufgedampft oder aufgesputtert, wird, dass die Metallschicht, insbesondere nach Schritt l), m), n) und/oder o), für sichtbares Licht transparent oder transluzent ist,
R) gegebenenfalls Plasmabehandlung mit dem Plasmagenerator und/oder Corona-Behandlung der Metallschicht gemäß Schritt Q'),
S) vorzugsweise Behandeln der nach Schritt Q') oder R) erhaltenen Metallschicht mit mindestens einer siliziumorganischen Verbindung, insbesondere mittels Plasmapolymerisation, unter Ausbildung einer Polysiloxanschicht,
T) vorzugsweise Plasmabehandlung mit dem Plasmagenerator und/oder Corona-Behandlung der Polysiloxanschicht gemäß Schritt S) und
U) Auftragen mindestens einer, insbesondere transparenten und/oder eingefarbten, Deckschicht auf die Schicht gemäß Schritt Q'), R), S) oder T), insbesondere auf die behandelte Polysiloxanschicht gemäß Schritt T).

5. Verfahren nach Anspruch 4, **dadurch gekennzeichnet, dass**
die Metallschicht, insbesondere Aluminiumschicht, in Schritt Q') in einer durchschnittlichen, insbesondere absoluten, Dicke im Bereich von 1 nm bis 50 nm, vorzugsweise im Bereich von 10 nm bis 40 nm, und besonders bevorzugt im Bereich von 15 nm bis 30 nm, vorliegt und/oder dass dem Schritt U) die Schritte S) und T) vorgelagert sind und/oder dass
benachbart anliegend zur Schicht Q') die Schicht PP-QQ), eine farbige Polysiloxanschicht, eine farbige Grundierungsschicht oder eine farbige Konversionsschicht vorliegt.

6. Verfahren nach Anspruch 4 oder 5, **dadurch gekennzeichnet, dass**
die Schritte D), M), N), Q), S), T) und U) oder D), M), N), Q'), S), T) und U) oder D), M), N), PP-QQ), Q'), S), T) und U) jeweils, insbesondere unmittelbar, aufeinander folgen oder
dass die Schritte D), M), N), O), Q), S), T) und U) oder D), M), N), O), Q'), S), T) und U) oder D), M), N), O), PP-QQ), Q'), S), T) und U) jeweils, insbesondere unmittelbar, aufeinander folgen oder
dass die Schritte D), E), F,), M), Q), S), T) und U) oder D), E), F,), M), Q'), S), T) und U) oder D), E), F,), M), PP-QQ), Q'), S), T) und U) jeweils, insbesondere unmittelbar, aufeinander folgen oder
dass die Schritte D), E), F,), M), O), Q), S), T) und U) oder D), E), F,), M), O), Q'), S), T) und U) oder D), E), F,), M), O), PP-QQ), Q'), S), T) und U) jeweils, insbesondere unmittelbar, aufeinander folgen oder
dass die Schritte D), G), H), M), Q), S), T) und U) oder D), G), H), M), Q'), S), T) und U) oder D), G), H), M), PP-QQ), Q'), S), T) und U) jeweils, insbesondere unmittelbar, aufeinander folgen oder
dass die Schritte D), G), H), M), O), Q), S), T) und U) oder D), G), H), M), 0), Q'), S), T) und U) oder D), G), H), M), O), PP-QQ), Q'), S), T) und U) jeweils, insbesondere unmittelbar, aufeinander folgen oder
dass die Schritte D), E), G), H), M), Q), S), T) und U) oder D), E), G), H), M), Q'), S), T) und U) oder D), E), G), H), M), PP-QQ), Q'), S), T) und U) jeweils, insbesondere unmittelbar, aufeinander folgen oder
dass die Schritte D), E), G), H), M), O), Q), S), T) und U) oder D), E), G), H), M), O), Q'), S), T) und U) oder D), E), G), H), M), O), PP-QQ), Q'), S), T) und U) jeweils, insbesondere unmittelbar, aufeinander folgen oder
dass die Schritte D), M), Q), S), T) und U) oder D), M), Q'), S), T) und U) oder D), M), PP-QQ), Q'), S), T) und U) jeweils, insbesondere unmittelbar, aufeinander folgen oder
dass die Schritte D), M), O)" Q), S), T) und U) oder D), M), O), Q'), S), T) und U) oder D), M), O), PP-QQ), Q'), S), T) und U) jeweils, insbesondere unmittelbar, aufeinander folgen oder
dass die Schritte D), G), H), Q), S), T) und U) oder D), G), H), Q'), S), T) und U) oder D), G), H), PP-QQ), Q'), S), T) und U) jeweils, insbesondere unmittelbar, aufeinander folgen oder
dass die Schritte D), G), H), O), Q), S), T) und U) oder D), G), H), 0), Q'), S), T) und U) oder D), G), H), O), PP-QQ), Q'), S), T) und U) jeweils, insbesondere unmittelbar, aufeinander folgen.

7. Verfahren nach einem der vorangehenden Ansprüche, **dadurch gekennzeichnet, dass** das nicht-metallische Substrat Glas, Keramik, Verbundfasermaterialien, Carbonmaterialien, Kunststoff, insbesondere, vorzugsweise eingefärbte, Kunststoffformteile oder, vorzugsweise eingefärbte, Kunststoffbeschichtungen, oder Holz, insbesondere Holzwerkstoffplatten, umfasst oder hieraus besteht oder dass das Metallsubstrat Metalle oder Metalllegierungen umfasst oder hieraus besteht, insbesondere ausgewählt ist aus der Gruppe bestehend aus Aluminium, Aluminiumlegierungen, Eisen, Eisenlegierungen, insbesondere Stahl oder Edelstahl, Kupfer, Kupferlegierungen, Titan, Titanlegierungen, Zink, Zinklegierungen, Nickel, Nicklegierungen, Molybdän, Molybdänlegierungen, Magnesium, Magnesiumlegierungen, Blei, Bleilegierungen, Wolfram, Wolframlegierungen, Mangan, Manganlegierungen, Messing, Bronze, Nickeldruckguss, Zinkdruckguss und Aluminiumdruckguss oder deren beliebigen Mischungen.

8. Verfahren nach einem oder mehreren der vorangehenden Ansprüche, **dadurch gekennzeichnet, dass**
der Schritt der Plasmabehandlung mit dem Plasmagenerator
- unter Einsatz von mindestens einem Inertgas, insbesondere Argon, oder
- unter Einsatz von mindestens einem Inertgas, insbesondere Argon, und Sauerstoff, Stickstoff, Kohlendioxid, Wasserstoff, Kohlenmonoxid, Wasserstoffperoxidgas, Wasserdampf, Ozon und/oder Luft, insbesondere Sauerstoff, oder
- unter Einsatz von Sauerstoff, Stickstoff, Wasserstoff, Kohlendioxid, Kohlenmonoxid, Wasserstoffperoxidgas, Wasserdampf, Ozon und/oder Luft, insbesondere Sauerstoff, vorzugsweise unter Ausschluss von Inertgasen,
durchgeführt wird.

9. Verfahren nach einem oder mehreren der vorangehenden Ansprüche, **dadurch gekennzeichnet, dass**
die Deckschicht Polyacrylatharze, Polyesterharze, Aminoplastharze oder Polyurethanverbindungen umfasst oder hieraus besteht und/oder dass die Deckschicht aus einem UV-härtenden Beschichtungsmaterial oder aus einem 1K- oder 2K-Einbrennlack gebildet ist, insbesondere eine UV-gehärtete Deckschicht oder eine 1K- oder 2K-Einbrennlack-Deckschicht darstellt.

10. Verfahren nach einem oder mehreren der vorangehenden Ansprüche, **dadurch gekennzeichnet, dass**
das nicht-metallisches Substrat, mindestens eine Polysiloxanschicht, die Grundierungsschicht, die matte Beschichtung, die Farbschicht, die Metallschicht und/oder die Deckschicht oder das Metallsubstrat, die mindestens eine Metallschicht, die mindestens eine Polysiloxanschicht, die Konversionsschicht, die Grundierungsschicht, die matte Beschichtung, die Farbschicht und/oder die Deckschicht, insbesondere die matte Beschichtung oder die Farbschicht, eine strukturierte Oberfläche aufweisen.

11. Beschichtetes nicht-metallisches Substrat, insbesondere beschichtetes Kunststoffsubstrat, vorzugsweise erhalten oder erhältlich nach einem Verfahren gemäß einem oder mehreren der Ansprüche 1 bis 3 oder gemäß einem oder mehreren der Ansprüche 7 bis 10, sofern und soweit direkt oder indirekt auf einen oder mehrere der Ansprüche 1 bis 3 rückbezogen, umfassend, in dieser Reihenfolge,
- ein, insbesondere plasma- und/oder coronabehandeltes, nicht-metallisches Substrat, insbesondere Kunststoffsubstrat;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht;
- gegebenenfalls mindestens eine, vorzugsweise plasma- und/oder coronabehandelte, insbesondere eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- vorzugsweise mindestens eine, vorzugsweise plasma- und/oder coronabehandelte, Farbschicht;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht, die für sichtbares Licht transparent oder transluzent ist;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

12. Beschichtetes nicht-metallisches Substrat nach Anspruch 11, **dadurch gekennzeichnet, dass**
die Metallschicht in einer durchschnittlichen, insbesondere absoluten, Dicke im Bereich von 1 nm bis 50 nm, vorzugsweise im Bereich von 10 nm bis 40 nm, und besonders bevorzugt im Bereich von 15 nm bis 30 nm, vorliegt und/oder zwischen Metallschicht und Deckschicht eine mittels Plasmapolymerisation mindestens einer siliziumorganischen Verbindung erhaltene plasma- und/oder coronabehandelte Polysiloxanschicht vorliegt und/oder dass
benachbart anliegend zur mittels Aufdampf- und/oder Sputter-Technik erhaltenen Metallschicht die Farbschicht, eine farbige Polysiloxanschicht, eine farbige Grundierungsschicht oder ein farbiges nicht-metallisches Substrat vorliegt.

13. Beschichtetes nicht-metallisches Substrat nach Anspruch 11 oder 12, **dadurch gekennzeichnet, dass**
das nicht-metallisches Substrat, mindestens eine Polysiloxanschicht, die Grundierungsschicht, die matte oder glänzende Beschichtung, die Farbschicht, die Metallschicht und/oder die Deckschicht, insbesondere die matte oder glänzende Beschichtung oder die Farbschicht, eine strukturierte Oberfläche aufweisen.

14. Beschichtetes Metallsubstrat, insbesondere erhalten oder erhältlich nach einem Verfahren gemäß einem oder mehreren der Ansprüche 4 bis 6 oder gemäß einem oder mehreren der Ansprüche 7 bis 10, sofern und soweit direkt oder indirekt auf einen oder mehrere der Ansprüche 4 bis 6 rückbezogen, umfassend, in dieser Reihenfolge,
- ein, insbesondere plasma- und/oder coronabehandeltes und/oder gereinigtes, Metallsubstrat;
- gegebenenfalls eine mittels Aufdampf- und/oder Sputter-Technik erhaltene, vorzugsweise plasma- und/oder coronabehandelte, Metallschicht, enthaltend oder bestehend aus einem zweiten Metall ausgewählt aus der Gruppe bestehend aus Titan, Hafnium und Zirkonium, insbesondere Zirkonium, oder aus einer zweiten Metalllegierung ausgewählt aus der Gruppe bestehend aus Titan-, Hafnium- und Zirkoniumlegierungen;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht;
- gegebenenfalls mindestens eine, vorzugsweise plasma- und/oder coronabehandelte, Konversionsschicht,
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- gegebenenfalls mindestens eine, vorzugsweise plasma- und/oder coronabehandelte und/oder eingefärbte, Grundierungsschicht;
- gegebenenfalls eine, insbesondere mittels Plasmapolymerisation mindestens einer siliziumorganischen Verbindung erhaltene, vorzugsweise plasma- und/oder coronabehandelte, Polysiloxanschicht,
- vorzugsweise mindestens eine, vorzugsweise plasma- und/oder coronabehandelte, Farbschicht;
- eine mittels Aufdampf- und/oder Sputter-Technik erhaltene, vorzugsweise plasma- und/oder coronabehandelte, Metallschicht, enthaltend oder bestehend aus einem ersten Metall ausgewählt aus der Gruppe bestehend aus Aluminium, Silber, Gold, Blei, Vanadium, Mangan, Magnesium, Eisen, Kobalt, Molybdän, Wolfram, Nickel, Kupfer, Chrom, Palladium, Platin, Titan, Zirkonium und Zink, insbesondere Aluminium, oder enthaltend oder bestehend aus einer ersten Metalllegierung ausgewählt aus der Gruppe bestehend aus Messing, Bronze, Stahl, insbesondere Edelstahl, Aluminium-, Magnesium- und Titanlegierungen, insbesondere Aluminiumschicht, die für sichtbares Licht transparent oder transluzent ist;
- vorzugsweise eine, insbesondere mittels Plasmapolymerisation mindestens einer siliziumorganischen Verbindung erhaltene, vorzugsweise plasma- und/oder coronabehandelte, Polysiloxanschicht,
- mindestens eine, insbesondere transparente und/oder eingefärbte, Deckschicht, vorzugsweise auf der behandelten Polysiloxanschicht.

15. Beschichtetes Metallsubstrat nach Anspruch 14, **dadurch gekennzeichnet, dass**
die zur Deckschicht benachbarte Metallschicht, insbesondere Aluminiumschicht, in einer durchschnittlichen, insbesondere absoluten, Dicke im Bereich von 1 nm bis 50 nm, vorzugsweise im Bereich von 10 nm bis 40 nm, und besonders bevorzugt im Bereich von 15 nm bis 30 nm, vorliegt und/oder dass zwischen Metallschicht und benachbarter Deckschicht eine mittels Plasmapolymerisation mindestens einer siliziumorganischen Verbindung erhaltene plasma- und/oder coronabehandelte Polysiloxanschicht vorliegt und/oder dass
benachbart anliegend zur mittels Aufdampf- und/oder Sputter-Technik erhaltenen Metallschicht die Farbschicht, eine farbige Polysiloxanschicht, eine farbige Grundierungsschicht oder eine farbige Konversionsschicht vorliegt.

16. Beschichtetes Metallsubstrat nach Anspruch 14 oder 15, **dadurch gekennzeichnet, dass**
das Metallsubstrat, die mindestens eine Metallschicht, die mindestens eine Polysiloxanschicht, die Konversionsschicht, die Grundierungsschicht, die matte oder glänzende Beschichtung, die Farbschicht und/oder die Deckschicht, insbesondere die matte oder glänzende Beschichtung oder die Farbschicht, eine strukturierte Oberfläche aufweisen.

17. Verwendung des nicht-metallisches Substrats nach einem der Ansprüche 11 bis 13 oder des Metallsubstrats nach einem der Ansprüche 14 bis 16 als Zubehörteil für den Automobilbau, Motorradbau, Fahrradbau oder Schiffbau, für Felgen, insbesondere Leichtmetallfelgen, Räder, insbesondere Leichtmetallräder oder als Bestandteil hiervon, für Sanitäreinrichtungsgegenstände, insbesondere als Armatur, oder als Bestandteil hiervon, für Karosserieinnen- oder Außenbauteile oder als Bestandteil hiervon, für Griffe oder Griffkomponenten, insbesondere Türgriffe oder als Bestandteil hiervon, für Profile oder Rahmen, insbesondere Fensterrahmen oder als Bestandteil hiervon, für Beschlagsysteme oder als Bestandteil hiervon, insbesondere Schilder und Türschilder, für Gehäuse oder als Verpackung oder als Bestandteil hiervon, für Innen- oder Außenbauteile von Schiffen oder als Bestandteil hiervon, für Haushaltsgeräte, insbesondere Kaffeemaschinen, oder Bestandteile hiervon, für Schmuckgegenstände oder als Bestandteil hiervon, für Edelbauteile oder als Bestandteil hiervon, für Innen- oder Außenmöbel oder für Bestandteile hiervon, beispielsweise Küchen-, Büro- oder Wohnmöbel, für Innen- oder Außenbauteile von Flugzeugen oder als Bestandteil hiervon, für Innen- oder Außenbauteile von Gebäuden oder als Bestandteil hiervon, für Heizkörper oder Rohre oder als Bestandteil hiervon, für Bauteile von Aufzügen oder als Bestandteil hiervon, für Bauteile von Elektronikkomponenten oder -Geräten oder als Bestandteil hiervon, für Bauteile von Küchengeräten, beispielsweise Kaffeemaschinen, oder als Bauteil von Kommunikationskomponenten oder -Geräten, insbesondere Handys, oder als Bestandteil hiervon.
